# EUROPEAN PATENT SPECIFICATION

(11) **EP 2 577 871 B1**
(45) Date of publication and mention of the grant of the patent: **09.09.2015**
(21) Application number: 11725273.4
(22) Date of filing: 27.05.2011
(51) Int. Cl.: H03K 19/177, G06F 13/16

(54) **INPUT/OUTPUT BANK ARCHITECTURE FOR AN INTEGRATED CIRCUIT**
I/O-BANKARCHITEKTUR FÜR EINE INTEGRIERTE SCHALTUNG
ARCHITECTURE DE BARRE OMNIBUS D'ENTRÉE/SORTIE POUR CIRCUIT INTÉGRÉ

(30) Priority: 04.06.2010 US 794530; 07.06.2010 US 795431; 04.06.2010 US 794605; 07.06.2010 US 795602
(43) Date of publication of application: 10.04.2013
(73) Proprietor: Xilinx, Inc., San Jose, California 95124 (US)
(72) Inventor: SCHULTZ, David, P., San Jose CA 95124 (US); HELTON, Sanford, L., San Jose CA 95124 (US); SWANSON, Richard, W., San Jose CA 95124 (US); PI, Tao, San Jose CA 95124 (US)
(74) Representative: Naismith, Robert Stewart
(86) International application number: PCT/US2011/038460
(87) International publication number: WO 2011/153107

(56) References cited:
- US-B1- 7 020 728
- US-B1- 7 167 023

## Description

### FIELD OF THE INVENTION

One or more embodiments disclosed within this specification relate to integrated circuits (ICs). More particularly, one or more embodiments relate to input/output (I/O) bank architectures for use within an IC.

### BACKGROUND

Programmable integrated circuit (IC) devices are a well-known type of IC that can be programmed to perform specified logic functions. One type of programmable IC, the field programmable gate array (FPGA), typically includes an array of programmable tiles. These programmable tiles can include, for example, input/output blocks (IOBs), configurable logic blocks (CLBs), dedicated random access memory blocks (BRAM), multipliers, digital signal processing blocks (DSPs), processors, clock managers, delay lock loops (DLLs), and so forth.

Each programmable tile typically includes both programmable interconnect circuitry and programmable logic circuitry. The programmable interconnect circuitry typically includes a large number of interconnect lines of varying lengths interconnected by programmable interconnect points (PIPs). The programmable logic circuitry implements the logic of a user design using programmable elements that can include, for example, function generators, registers, arithmetic logic, and so forth.

The programmable interconnect and programmable logic circuits are typically programmed by loading a stream of configuration data into internal configuration memory cells that define how the programmable elements are configured. The configuration data can be read from memory (e.g., from an external PROM) or written into the FPGA by an external device. The collective states of the individual memory cells then determine the function of the FPGA.

Another type of programmable IC is the complex programmable logic device, or CPLD. A CPLD includes two or more "function blocks" connected together and to input/output (I/O) resources by an interconnect switch matrix. Each function block of the CPLD includes a two-level AND/OR structure similar to those used in programmable logic arrays (PLAs) and programmable array logic (PAL) devices. In CPLDs, configuration data is typically stored on-chip in non-volatile memory. In some CPLDs, configuration data is stored on-chip in non-volatile memory, then downloaded to volatile memory as part of an initial configuration (programming) sequence.

For all of these programmable ICs, the functionality of the device is controlled by data bits provided to the device for that purpose. The data bits can be stored in volatile memory (e.g., static memory cells, as in FPGAs and some CPLDs), in non-volatile memory (e.g., FLASH memory, as in some CPLDs), or in any other type of memory cell.

Other programmable ICs are programmed by applying a processing layer, such as a metal layer, that programmably interconnects the various elements on the device. These programmable ICs are known as mask programmable devices. Programmable ICs can also be implemented in other ways, e.g., using fuse or antifuse technology. The phrase "programmable IC" can include, but is not limited to these devices and further can encompass devices that are only partially programmable. For example, one type of programmable IC includes a combination of hard-coded transistor logic and a programmable switch fabric that programmably interconnects the hard-coded transistor logic.

The document US7167023 discloses interface architectures for programmable logic devices to interface to e.g. SDRAM devices. The document suggests to partition banks of I/O pins byte-wise into smaller sections, each having at least one pin dedicated to the strobe signal DQS and others to DQ data signals.

### SUMMARY

The invention within this specification relates to an integrated circuit as defined in independent claim 1 and a method of operation for an integrated circuit as defined in independent method claim 8. Preferred embodiments are defined in the dependent claims.

### BRIEF DESCRIPTION OF THE DRAWINGS

FIG. 1 is a first block diagram illustrating an input/output (I/O) bank of an integrated circuit (IC) in accordance with an embodiment disclosed within this specification.
FIG. 2 is a second block diagram illustrating a portion of an I/O bank of an IC in accordance with another embodiment disclosed within this specification.
FIG. 3 is a third block diagram illustrating another aspect of an I/O bank in accordance with another embodiment disclosed within this specification.
FIG. 4 is a fourth block diagram illustrating another aspect of an I/O bank in accordance with another embodiment disclosed within this specification.
FIG. 5 is a fifth block diagram illustrating another aspect of an I/O bank in accordance with another embodiment disclosed within this specification.
FIG. 6 is a sixth block diagram illustrating a memory interface system disposed within an IC in accordance with another embodiment disclosed within this specification.
FIG. 7 is a seventh block diagram illustrating a system for managing a strobe signal in accordance with another embodiment disclosed within this specification.
FIG. 8 is an eighth block diagram illustrating a system for delaying signals in accordance with another embodiment disclosed within this specification.
FIG. 9 is a ninth block diagram illustrating a system for processing a strobe signal in accordance with another embodiment disclosed within this specification.
FIG. 10 is a tenth block diagram illustrating a strobe detector in accordance with another embodiment disclosed within this specification.
FIG. 11 is a signal diagram illustrating different states of a strobe signal that can be detected and/or measured in accordance with another embodiment disclosed within this specification.
FIG. 12 is an example of a stream of bits determined by oversampling the strobe signal in accordance with another embodiment disclosed within this specification.

### DETAILED DESCRIPTION OF THE DRAWINGS

While the specification concludes with claims defining the features of one or more embodiments that are regarded as novel, it is believed that the one or more embodiments will be better understood from a consideration of the description in conjunction with the drawings. As required, one or more detailed embodiments are disclosed herein; however, it is to be understood that the one or more embodiments disclosed are merely exemplary. Therefore, specific structural and functional details disclosed within this specification are not to be interpreted as limiting, but merely as a basis for the claims and as a representative basis for teaching one skilled in the art to variously employ the inventive arrangements in virtually any appropriately detailed structure. Further, the terms and phrases used herein are not intended to be limiting, but rather to provide an understandable description of one or more embodiments disclosed herein.

One or more embodiments disclosed within this specification relate to integrated circuits (ICs) and, more particularly, to a bank of inputs and outputs for use within an IC. In accordance with one or more embodiments disclosed herein, an architecture for a bank of inputs and outputs (I/O bank) is provided that facilitates communication with source synchronous devices. The architecture allows the I/O bank to be utilized as one or more independently configurable interfaces for communicating with one or more source synchronous devices located off-chip.

In one aspect, clock resources can be included within the I/O bank itself, e.g., local to the particular pins of the I/O bank used to implement a source synchronous interface. A greater level of control over clock functions can be achieved through the inclusion of clock generation and management resources within the I/O bank itself. Further control over clock functions can be facilitated by limiting the number of pins within the I/O bank that are controlled by each clock resource. This local approach of clock generation and management within the I/O bank for a limited set of pins provides lower skew and higher performance than other conventional I/O bank architectures. Conventional I/O banks, for example, typically include or are driven by one or more global clocks that drive many circuit elements throughout the IC. The global clock signals, not being locally generated with respect to the I/O bank, are subject to loading effects that induce jitter, delay, and the like on the clock signals thereby reducing the accuracy and reliability of the I/O bank as a synchronous interface.

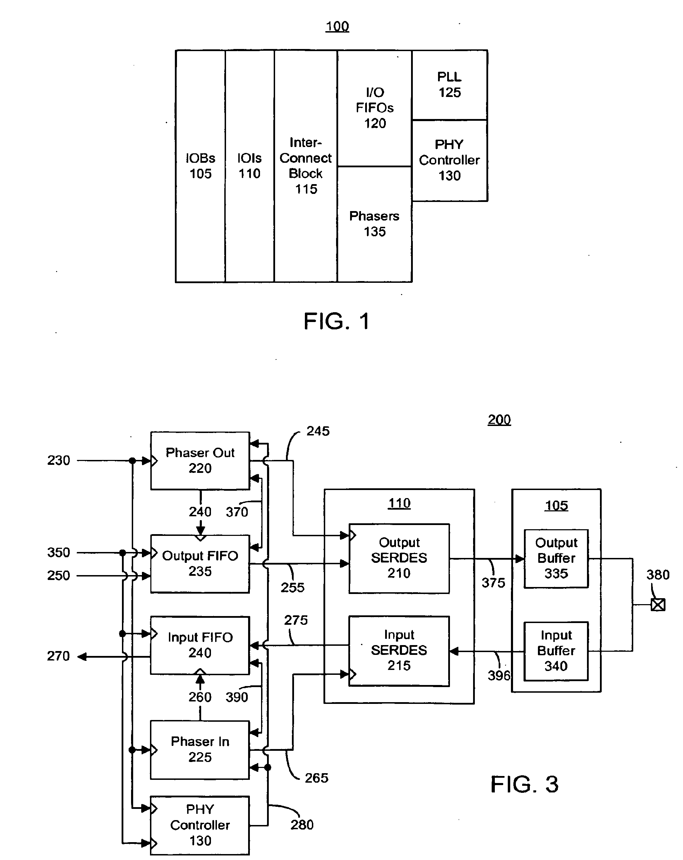

FIG. 1 is a first block diagram illustrating an I/O bank 100 of an integrated circuit in accordance with an embodiment disclosed within this specification. I/O bank 100 can be configured to implement a source synchronous interface that facilitates communication between the IC within which I/O bank 100 is disposed and any of a variety of different types of source synchronous devices. In an embodiment, the IC within which one or more I/O banks, such as I/O bank 100, can be implemented can be a programmable IC. The one or more embodiments disclosed herein, however, are not intended to be limited to implementation or use within programmable ICs. Rather, I/O bank 100 can be implemented in any of a variety of different types of ICs. For example, I/O bank 100 can be implemented within a processor having an embedded memory controller, an application specific IC, a mixed signal IC, or other type of non-programmable IC.

One example of a source synchronous device that can be coupled to I/O bank 100 is a memory device. I/O bank 100 can be coupled to any of a variety of dual data rate (DDR) synchronous dynamic random access memory (SDRAM) devices. Examples of DDR type SDRAM devices can include, but are not limited to, DDR type memory devices, DDR2 type memory devices, DDR3 type memory devices, low power DDR (LPDDR or mobile DDR) type memory devices, or the like. Further examples can include, but are not limited to, quad data rate II (QDRII), reduced latency dynamic random access memory (RLDRAMII), networking sources, multimedia sources, or the like.

In general, I/O bank 100 can include a plurality of IOBs 105, a plurality of I/O interconnect tiles (IOIs) 110, an interconnect block 115, and a plurality of I/O first-in-first-out memories (I/O FIFOs) 120. I/O bank 100 also can include a phase lock-loop (PLL) 125, a physical interface controller (PHY controller) 130, and a plurality of phasers 135. Taken collectively, IOBs 105 and IOIs 110 form I/O circuitry of I/O bank 100. IOBs 105 represent one or more circuit elements that implement input and output functions. Each IOB, for example, can be configured for bi-directional operation and, as such, can include an input buffer and an output buffer. The input buffer and the output buffer can be coupled to a pad of the IC through which a signal, e.g., a single bit signal, can be output to a target external to the IC via the output buffer or through which a signal can be received from the source external to the IC through the input buffer. IOBs 105 are coupled to IOIs 110. In general, IOIs 110 can include a plurality of serializers and a plurality of deserializers.

As shown, IOIs 110 can be coupled to interconnect block 115, which in turn is coupled to I/O FIFOs 120. In one or more embodiments, interconnect block 115 can be implemented as interconnect circuitry that is used to couple configurable circuit elements in two different columns of circuitry. In this regard, while I/O FIFOs 120 are separated by IOIs 110, I/O FIFOs 120 can be said to be disposed immediately adjacent to IOIs 110 as interconnect block 115 includes routing resources that can be, at least in part, configurable.

Interconnect block 115 provides interconnects to facilitate programmable routing between IOIs 110 and I/O FIFOs 120. For example, in the case where the IC is a programmable IC, routes coupling I/O FIFOs 120 with IOIs 110 can be determined according to configuration data loaded into configuration memory cells of the programmable IC. Interconnect block 115 also provides access to IOIs 110 from the programmable fabric that implements user-specified circuitry of the IC, e.g., when the IC is configured as a programmable IC such as a field programmable gate array (FPGA).

Though interconnect block 115 provides programmable connectivity between IOIs 110 and I/O FIFOs 120, one or more signals to be described herein can be directly routed across the area represented by interconnect block 115. The direct routes facilitate faster and more efficient signal routing for more sensitive signals. The signal routes, for example, can be considered "hardened" or said to be a "hard circuit." As such, the hardened routes, as compared to programmable routes, induce fewer artifacts such as jitter and delay on the signals.

A "hard circuit" refers to a predetermined and, thus, preconfigured circuit, whether a circuit block or a wire, e.g., a route, that is implemented within an IC. A hard circuit, for example, while sometimes being at least partially configurable in some respect, is not instantiated by loading configuration data into the programmable IC. The hard circuit exists on the programmable IC irrespective of whether configuration data is loaded and, in general, is dedicated to a particular purpose as are the various blocks described herein.

By comparison, a "soft circuit" refers to a circuit design that is specified using software, e.g., a programmatic description of the circuit specified using a hardware description language, netlist, or the like. The programmatic description of the circuit design is converted, e.g., compiled, into configuration data that can be loaded into configuration memory cells of the programmable IC. Loading the configuration data into configuration memory cells effectively instantiates a circuit design within the programmable IC. More particularly, the configuration data, when loaded into the programmable IC, configures general programmable or configurable circuitry within the programmable IC to implement the specified circuit design and/or routes, e.g., wiring.

I/O FIFOs 120 can include one or more input FIFO memories and one or more output FIFO memories. Each output FIFO memory can be configured to send data and/or commands from the IC to the source synchronous device. Each input FIFO memory can be configured to receive data from the source synchronous device within the IC. Each of I/O FIFOs 120 can be configured to implement an asynchronous clock domain boundary. For example, each of I/O FIFOs 120 can include one port that is configured to operate at a first frequency that is approximately equal to the frequency of operation of the source synchronous device (SSD frequency) and a second port that is configured to operate at a second, and typically slower, frequency at which one or more other systems within the IC are, or can be, configured to operate (IC frequency).

PLL 125 can generate one or more clock signals utilized, for example, by PHY controller 130 and phasers 135. PHY controller 130 can provide centralized control over phasers 135. In general, PHY controller 130 can control the transfer of data through I/O FIFOs 120 responsive to control words received from a user circuit such as a memory controller, for example. In one or more embodiments, PHY controller 130 also can facilitate an asynchronous clock boundary by receiving the control words at a rate corresponding to the IC frequency. PHY controller 130, however, can execute the received control words and control operation of at least a portion of I/O FIFOs 120, via phasers 135, at or about the SSD frequency.

Phasers 135 are a type of clock resource configurable to provide a variety of clock generation and clock management functions. Each of phasers 135, for example, can create the read interface and/or write interface clocks used within I/O bank 100. Phasers 135 can generate clock signals for distribution to the components within I/O bank 100 that operate at the SSD frequency. Each of phaser 135, for example, can be configured to receive a continuous frequency reference clock and one or more of phasers 135 can be configured to receive a non-continuous phase reference. Additional control and/or reset signals also can be provided to each of phasers 135.

As shown, phasers 135, like I/O FIFOs 120, can be disposed within a column directly adjacent to I/O circuitry and, for example, IOIs 110. Locating phasers 135 adjacent to I/O circuitry allows clock routing to be direct and short, thereby reducing and/or eliminating jitter injection points that arise from the use of multiple stages of circuitry and coupling and/or crossing signal lines.

Each of phasers 135 can, for example, establish frequency lock with the continuous frequency reference clock that can be provided by PLL 125. Once frequency lock is achieved, each of phasers 135 can output one or more signals having a fixed phase relationship to the phase reference clock. The phase reference clock, for example, can be a data strobe signal, e.g., a "DQS signal," that is received via an external pin from the source synchronous device. One or more of phasers 135, for example, also can perform strobe signal detection and capture as well as generate further clock pulses that are phase and frequency aligned to a received strobe signal when the strobe signal terminates or discontinues pulses. The additional pulses allow data to be clocked through I/O bank 100 for output to one or more other systems or circuit elements within the IC.

In one or more embodiments, each of phasers 135 can be configured to generate a full-rate clock, e.g., at approximately the same frequency as the reference signal or SSD frequency, and one or more divided clocks. Each divided clock can be a frequency divided version of the full-rate clock. The divisor used can be selectable, e.g., one, two, four, etc. Each of the frequency divided clocks also can have a selectable phase variance or relationship with respect to the full-rate clock. For example, each of phasers 135 can output one or more divided clocks. The phase of each divided clock can be set within each phaser 135 in increments, for example, of approximately one-half of the period of the full-rate clock. The dividing circuitry disposed within each of phasers 135 can be programmable. Accordingly, when a phaser 135 is reset, the phase relationship specified via the programmability of phaser 135 is maintained or otherwise preserved.

For example, when the frequency divided clocks have a frequency that is approximately one half of the full rate clock, the phase variance can be selectable in terms of being approximately in phase or approximately 180 degrees out of phase with the full rate clock. When the frequency divided clocks have a frequency that is approximately one-fourth of the full rate clock, the phase variance can be selectable in terms of being approximately in phase, approximately 90 degrees out of phase, approximately 180 degrees out of phase, or approximately 225 degrees out of phase with the full rate clock.

By including clocking circuitry that is dedicated for use in implementing a source synchronous interface within I/O bank 100, distortions and jitter in the clocking signals can be minimized. In one or more embodiments, one input phaser and one output phaser can be implemented for a limited number of IOBs 105. For example, each set of 12 IOBs 105 can be controlled by one input phaser and/or one output phaser as the case may be. Restricting the number of pads controlled by a particular one of phasers 135 reduces the load on the clock signals and further reduces distortions and/or jitter on the clock signals.

By comparison, conventional I/O banks not only utilize global clock signals that are subject to heavy loading, but typically each pin and its associated I/O circuitry is clocked by a same clock signal. Thus, in cases where each I/O bank includes approximately 40-50 pins, each of the 40-50 pins is controlled by a same clock signal. In this regard, conventional I/O banks provide little control over the clock signal for purposes of clock/data alignment as is necessary for implementing a source synchronous interface.

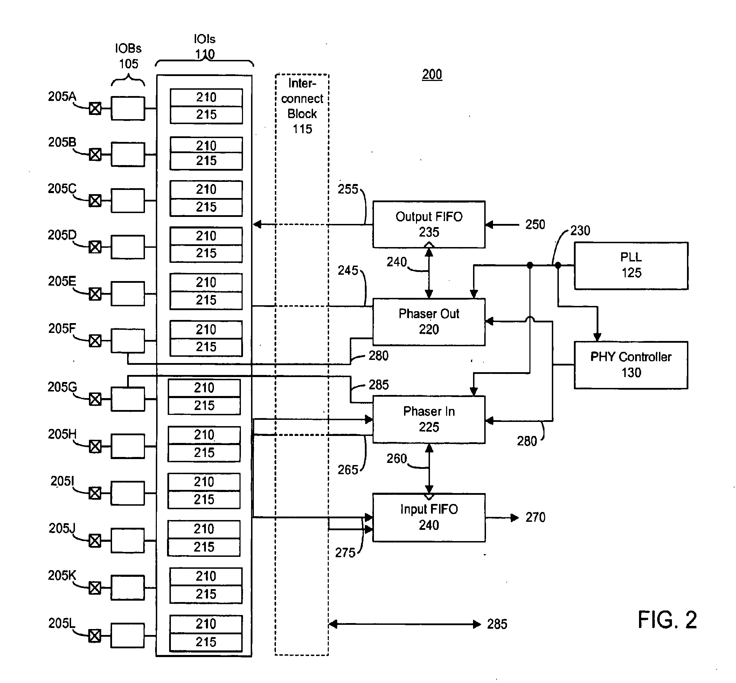

FIG. 2 is a second block diagram illustrating a portion of an I/O bank of an integrated circuit in accordance with another embodiment disclosed within this specification. More particularly, FIG. 2 illustrates a byte clock group 200 of I/O bank 100 in accordance with another embodiment. As noted, byte clock group 200 represents a limited portion of I/O bank 100. In one or more embodiments, byte clock group 200 can include 12 IOBs 105, with each IOB being coupled to one of 12 pads illustrated as pads 205A-205L. Each IOB 105 can be configured for bi-directional operation. For example, in one or more embodiments, I/O bank 100 can include four byte clock groups of the variety illustrated in FIG. 2. As shown, byte clock group 200 includes dedicated clock generation and clock management resources for use exclusively by components within byte clock group 200. In this regard, each byte clock group included within I/O bank 100 can control the clock signals used therein independently of each other byte clock group within the same I/O bank.

IOIs 110 can include a plurality of output serial/deserializers (SERDES) 210 and a plurality of input SERDES 215. In one or more embodiments, byte clock group 200 can include 12 output SERDES 210 and 12 input SERDES 215. For example, each IOB 105 can be coupled to one output SERDES 210 and one input SERDES 215. Each output SERDES 210 can be configured to receive data from within the IC and serialize the data before sending to the source synchronous device through IOBs 105 and corresponding pads 205A-205L. Each input SERDES 215 can be configured to receive data from the source synchronous device and deserialize the received data before providing the data to other components or systems within the IC, e.g., via interconnect block 115, in FIFO 220, or the like.

Interconnect block 115 provides programmable interconnects to facilitate programmable routing between IOIs 110 and I/O FIFOs 120. As noted, interconnect block 115 also provides access to IOIs 110 from the programmable fabric of the IC, e.g., when the IC is a programmable IC. In this regard, signal 285 can represent one or more signals that can be coupled to the programmable fabric of the IC to send one or more signals received within byte clock group 200 to the programmable fabric or to receive one or more signals from the programmable fabric for output to the source synchronous device.

Phaser out 220 and phaser in 225 provide a mechanism for creating phase-adjusted clock signals for byte clock group 200. In general, phaser out 220 can be configured to generate write interface clocks. In some cases, phaser out 220 also can be used to generate read interface clocks. Phaser in 225 can be configured to generate read interface clocks. The phasers, in reference to both phaser out 220 and phaser in 225, can be used to implement a source synchronous interface including multiple data lanes or channels. Each data lane or channel, in general, can utilize a same clock signal, though each clock signal can have a unique phase. Phaser out 220 and phaser in 225 each provide clock signals to the output SERDES 210 and the input SERDES 215 as well as 10 of the 12 IOBs 105.

In general, phaser out 220 and phaser in 225 can utilize frequency-locked and voltage regulated delay lines to phase shift source synchronous data and/or control signals. For example, referring to phaser in 225, the incoming clock (not shown) that can be adjusted can be an incoming data strobe signal, e.g., in the case of DDR2 and/or DDR3, or a free running clock in the case of QDRII, RLDRAMII, networking, multimedia, or the like. Phaser out 220 can be configured to adjust an output clock, e.g., signals 260 and/or 265, used with either data and/or control signals.

Operation of phaser out 220 and phaser in 225 can be coordinated or controlled by PHY controller 130 to be described in greater detail within this specification. Phaser out 220 and phaser in 225 can receive a reference signal 230, e.g., a frequency reference signal, from PLL 125. Signal 230 can be at the SSD frequency. From the received reference signal 230, phaser out 220 can generate one or more clock signals at the SSD frequency with varying phase offsets. For example, phaser out 220 can generate a plurality of clock signals at the SSD frequency wherein each clock signal has a different, e.g., a unique, phase offset. Phaser out 220 is coupled to output FIFO 235 via signal 240 and coupled to each output SERDES 210 via signal 245. Signals 240 and 245 can represent, at least in part, one or more clock signals generated and provided by phaser out 220 at the SSD frequency with varying phase offsets for controlling portions of the data output path that operate at the SSD frequency. For example, phaser out 220 can provide clocking signals necessary to operate output SERDES 210 and an output port of output FIFO 235 at a rate corresponding to, or clocked by, the SSD frequency.

Phaser out 220 can generate an output clock signal at approximately the SSD frequency, a frequency divided version of the output clock signal, and a phase-adjusted version of the output clock signal wherein the phase can be selectively altered. The output clock signal, e.g., the full rate clock signal, can be frequency matched with the frequency reference signal, e.g., signal 230. The output clock signal can have a fixed phase offset as compared to a received phase reference signal (not shown). The phase reference signal, for example, can be a non-continuous signal that is maintained within predetermined bounds. In one example, the phase reference signal can be a strobe or DQS signal.

Phaser out 220 further can generate a phase shifted version, e.g., a 90-degree phase shifted version, of the full rate clock signal that can be utilized when byte clock group 200 is used to implement an interface for communicating with DDR3, QDRII, RLDRAMII, networking, multimedia, etc. type of devices. In one or more embodiments, phaser out 220 can utilize frequency-locked voltage-regulated delay lines to perform phase adjustment. The phase relationship between the full rate clock and the phase shifted version of the full rate clock can be specified using phase increment/decrement control signals. Each increment control signal can cause a predetermined amount of delay, e.g., some fraction such as 1/32 of the period of the full rate clock signal as can be provided by a delay line within phaser out 220, to be added to the phase shifted version of the full rate clock. Each decrement control signal can cause the predetermined amount of delay to be removed from the phase shifted version of the full rate clock. In this manner, the phase shifted version of the full rate clock can be phase-adjusted with respect to the full rate clock to a desired phase offset.

As noted, the frequency divided clock signal can be phase aligned with the full rate clock signal. In one or more embodiments, a phase offset of the frequency divided signal clock signal output from phaser out 220 can be selected. The phase offset of the frequency divided signal can be specified in coarse increments of approximately one-half of the period of the reference signal.

Output FIFO 235 can be configured as a dual port memory having an input port and an output port that can operate asynchronously with respect to one another. The input port of output FIFO 235 can be coupled, for example, to a user circuit, such as a memory controller (not shown), via signal 250 over which data is received and clocked into output FIFO 235 at a rate corresponding to the IC frequency. In one or more embodiments, the input port of output FIFO memory 235 can be controlled by the user circuit which can, for example, provide data to output FIFO 235 via signal 250 and further control write enabling of the input port of output FIFO 235.

The output port of output FIFO 235 can output data via signal 255 to output SERDES 210 through interconnect block 115. The output port of output FIFO 235 can be clocked according to a clock signal at the SSD frequency that is generated by phaser out 220 and represented, at least in part, by signal 240. Phaser out 220 further can regulate the output port of output FIFO 235, e.g., read enabling the output port, to control the flow of data output from out FIFO 235 to output SERDES 110. Phaser out 220 controls the flow of data output from out FIFO 235 responsive to commands received via signal 280 from PHY controller 130. Output SERDES 210 can serialize data received from output FIFO 235 and output the resulting serialized data to IOBs 105 and pads 205A-205E and 205H-205L.

In one or more embodiments, output FIFO 235 can be configured to operate in a first mode having 12 data inputs and 12 data outputs. Each data input and each data output can be configured to be 4 bits wide. Output FIFO 235, for example, can be configured in this mode to accommodate eight entries. In a second and alternate mode, output FIFO 235 can be configured to have 10 data inputs with each being 8 bits wide. Output FIFO 235 can be configured to have 10 data outputs with each data output being 4 bits wide. In the second mode, output FIFO 235 can accommodate 8 entries. In the second mode, a 2:1 multiplexer can be added in the output data path and used to serialize the input data to a smaller output data width. The second mode of operation can be used, for example, when the output clock controlling the output port of output FIFO 235 is approximately twice the frequency that drives the input port of output FIFO 235.

Like phaser out 220, phaser in 225 can generate one or more clock signals at the SSD frequency. In one or more embodiments, phaser in 225 can generate a plurality of clock signals at the SSD frequency wherein each clock signal has a different phase. Phaser in 225 is coupled to input FIFO 240 via signal 260 and coupled to input SERDES 215 via signal 265. Signals 260 and 265 can represent, at least in part, one or more clock signals generated and provided by phaser in 225 at the SSD frequency for controlling portions of the data input path that operate at the SSD frequency. For example, phaser in 225 can provide clocking signals necessary to operate input SERDES 215 and an input port of input FIFO 240 at a rate corresponding to, e.g., clocked by, the SSD frequency.

For example, phaser in 225 can be configured to perform fine adjustment of the clock signal that is used to capture incoming, e.g., read, data. Phaser in 225 further can perform functions such as detecting a first pulse of a strobe from the source synchronous device and create a free running clock that is phase aligned with the strobe signal that is received and detected. Phaser in 225, unlike phaser out 220, for example, can include a squelch controller that, responsive to a squelch control signal (not shown), can synchronously squelch a received reference signal such as a phase reference signal. The term "squelch" or "squelching" can refer to pulling a signal either high or low and retaining the signal in that state for a period of time, e.g., the period of time the signal is to be squelched. Whether the signal is pulled high or low can vary according to the configuration of the particular circuit to which the signal is being provided.

Input FIFO 240 can be configured as a dual port memory having an input port and an output port that can operate asynchronously with respect to one another. The output port of input FIFO 240 can be coupled, for example, to user circuitry such as a memory controller via signal 270, over which data is read out of input FIFO 240 at a rate corresponding to the IC frequency. In one or more embodiments, the output port of input FIFO 240 can be controlled by the user circuit which can, for example, read data out of input FIFO 240 via signal 270 and further control read enabling of the output port of input FIFO 240.

The input port of input FIFO 240 can receive data via signal 275 from input SERDES 215 through interconnect block 115. The input port can be clocked according to a clock signal at the SSD frequency that is generated by phaser in 225 and represented, at least in part, by signal 260. Phaser in 225 can regulate the input port of input FIFO 240, e.g., write enabling the input port, to control the flow of data into input FIFO 240 from each input SERDES 215. Phaser in 225, for example, operates under the control of PHY controller 130 to respond to commands received via signal 280. Each input SERDES 215 can deserialize data received from the source synchronous device via pads 205A-205E and 205H-205L. Each input SERDES 215 can output the resulting deserialized data to input FIFO 240.

In one or more embodiments, input FIFO 240 can be configured to operate in a first mode having 12 data inputs and 12 data outputs. Each data input and each data output can be configured to be 4 bits wide. Input FIFO 240, for example, can be configured in this mode to accommodate eight entries. In a second and alternate mode, input FIFO 240 can be configured to have 10 data inputs, with each being 8 bits wide. Out FIFO 235 can be configured to have 10 data outputs, with each data output being 4 bits wide. In the second mode, input FIFO 240 can accommodate 8 entries. In the second mode, data can be demultiplexed to form a larger output width. The second mode of operation can be used, for example, when the output port of input FIFO 240 is clocked approximately one-half of the frequency that clocks the input port of input FIFO 240.

In one or more embodiments, output FIFO 235 and input FIFO 240 can be physically aligned within byte clock group 200 as shown. Thus, within a given I/O bank, including four byte clock groups, each of the FIFOs, e.g., eight FIFOs in total corresponding to four input FIFOs and four output FIFOs, can be physically aligned with the particular IOBs belonging to the same byte clock group as the I/O FIFOs.

In one or more embodiments, connections between the I/O FIFOs and the IOIs can be configured in such a way to allow for data to be transferred using a single hop or wire through the interconnect block. Connections configured with a single hop, for example, can be implemented using a fixed mapping of signals between IOBs and I/O FIFOs. Similarly, the clock signals provided by each phaser and the read and/or write enable signals provided by each phaser to the I/O FIFOs can be dedicated, e.g., hardened, connections rather than clocks routed from the interconnect fabric typically used within a programmable IC.

As shown, each of phaser out 220 and phaser in 225 can have one or more direct and dedicated signal connections that can be coupled to IOB 205F and 205G. Phaser out 220 out can be directly coupled to IOB 205F via signal 280. Phaser in 225 can be directly coupled to IOB 205G via signal 285. Signals 280 and 285 can represent one or more signals that effectively circumvent interconnect block 115 and/or IOI 110. For example, signals 280 and 285 can be implemented using a direct wire that is not a part of interconnect block 115 or IOI 110 and, thus, is not programmable. Signals 280 and 285 can be contrasted with the connections between I/O FIFOs and IOIs previously described in that such connections, while limited to a single hop, still are part of, and flow through, interconnect block 115. Further, signals 280 and 285 flow directly to IOBs 105 and circumvent IOIs 110 as shown.

For example, signal 280 can be used by phaser out 220 to output a strobe signal that can be used to clock data that is output from the IC to the SSD when the IC is writing data. Signal 285 can be used by phaser in 225 to receive a strobe signal sent from the SSD when the IC is reading data. In illustration, while byte clock group 200 can include 12 IOBs 105, ten of IOBs 105 can be reserved for communicating data, e.g., sending or receiving. Two of the IOBs 105 can be reserved for clock signals and can be coupled to signal 280 and/or 285. For example, pads 205F and 205G can be reserved for coupling to signals 280 and/or 285 respectively, though other pads and/or corresponding IOBs 105 can be reserved as may be desired. As shown, pads 205F and 205G can be substantially aligned so that a relatively direct and straight signal path exists between phaser out 220 and pad 205F and phaser in 225 and pad 205G.

In one or more embodiments, phaser out 220 and phaser in 225 can be configured to have a frequency range of approximately 125 MHz to approximately 1066 MHz. This frequency range facilitates data rates from approximately 250 Mbps for DDR2 configurations to approximately 2133 Mbps for DDR3 configurations. In the case of DDR3 DIMM interfaces, for example, all I/O in an I/O bank can be configured as data (DQ) pins or as data strobe (DQS) pins. In another example, each byte clock group including 12 I/Os and associated phasers, e.g., phaser out 220 and phaser in 225, can be used independently.

In the case of a DDR3 configuration, which utilizes bi-directional data strobes and data, both phaser out 220 and phaser in 225 of byte clock group 200, e.g., any phaser out or phaser in a byte clock group for DDR3, is used. By comparison, in the case of RLDRAMII, which utilizes unidirectional data pins, only phaser out 220 or phaser in 225 can be used depending on whether byte clock group 200 is used for reading or writing data. Taking another example, in the case of QDRII+ interfaces, the read data clocks called CQ/CQ# are nominally complementary signals but have separate phase requirements. Phaser in 225 can be configured to generate the CQ signal and phaser out 220 can be configured to function as a secondary phaser in to process the CQ# signal.

FIG. 3 is a third block diagram illustrating another aspect of an I/O bank configured in accordance with another embodiment disclosed within this specification. FIG. 3 illustrates an example of a data architecture for byte clock group 200. For purposes of illustration, only a single IOI 110 and a single IOB 105 are shown. Byte clock group 200 can include phaser out 220, phaser in 225, output FIFO 235, input FIFO 240, and PHY controller 130. IOI 110 can be configured to include output SERDES 210 and input SERDES 215. IOBs 105 can include an output buffer 335 and an input buffer 340.

Phaser out 220 and phaser in 225 can receive a clock signal 230, which can be at the SSD frequency. In one or more embodiments, clock signal 230 can be generated locally by a source (not shown). Phaser out 220, in turn, can generate one or more clock signals at the SSD frequency. In one or more embodiments, phaser out 220 can generate a plurality of clock signals at the SSD frequency wherein each clock signal has a different phase offset. Phaser out 220 is coupled to output FIFO 235 via signal 240 and coupled to OUTPUT SERDES 210 via signal 245. Signals 240 and 245 can represent, at least in part, one or more clock signals generated and provided by phaser out 220 at the SSD frequency for controlling those portions of the data output path that operate at the frequency of the memory device.

It should be appreciated that output SERDES 210 can require an additional clock signal to facilitate serialization of data. Thus, in one or more embodiments, signal 245 can represent a first clock signal at the SSD frequency and a second clock signal having a frequency that is a fraction of the SSD frequency, wherein the fraction used depends upon the degree of serialization being performed by output SERDES 210. The second clock signal, for example, can be ½, 1/3, ¼, 1/6, 1/7, 1/8, or the like.

Output FIFO 235 can be configured as a dual port memory having an input port and an output port that can operate asynchronously with respect to one another. The input port of output FIFO 235 can be coupled to a memory controller or other user circuit via signal 250, over which data is received and, thus, clocked by clock signal 350 at the IC frequency. In one or more embodiments, the input port of output FIFO 235 can be write enabled via the memory controller. The output port of output FIFO 235 can be indirectly controlled by PHY controller 130 via signals 280 and 370 to read data from output FIFO 235 responsive to received PHY control words from the memory controller. For example, PHY controller 130 can instruct, via signal 280, phaser out 220 to read enable the output port of output FIFO 235 via signal 370. As shown, PHY controller 130 also can receive clock signal 350 corresponding to the IC frequency and clock signal 230 corresponding to the SSD frequency. Data can be read from output FIFO 235 only when the data belonging to, or associated with, the received PHY control word(s) are available.

The output port of output FIFO 235 can output data to output SERDES 210 through signal 255. The output port can be clocked according to a clock signal at the SSD frequency that is generated by phaser out 220 and represented, at least in part, by signal 240. Phaser out 220 can regulate the output port of output FIFO 235, e.g., read enabling the output port, to control the flow of data from output FIFO 235 to output SERDES 210 via signal 370. Output SERDES 210 serializes data received from output FIFO 235 via signal 255 and outputs the resulting serialized data to output buffer 335 via signal 375. Output buffer 335 then outputs the serial data to the memory device via pin 380.

Like phaser out 220, phaser in 225 can generate one or more clock signals at the SSD frequency. In one or more embodiments, phaser in 225 can generate a plurality of clock signals at the SSD frequency wherein each clock signal has a different phase. Phaser in 225 is coupled to input FIFO 240 via signal 260 and coupled to input SERDES 215 via signal 265. Signals 260 and 265 can represent, at least in part, one or more clock signals generated and provided by phaser in 225 at the SSD frequency for controlling those portions of the data input path that operate at the frequency of the memory device.

Input SERDES 215, like output SERDES 210, can require an additional clock signal to facilitate de-serialization of data. Thus, in one or more embodiments, signal 265 can represent a first clock signal at the SSD frequency and a second clock signal having a frequency that is a fraction of the SSD frequency, wherein the fraction used depends upon the degree of deserialization being performed by input SERDES 215. The second clock signal, for example, can be ½, 1/3, ¼, 1/6, 1/7, 1/8, or the like.

Input FIFO 240 can be configured as a dual port memory having an input port and an output port that can operate asynchronously with respect to one another. The output port of input FIFO 225 can be coupled to the memory controller via signal 270, over which data is sent. In one or more embodiments, the output port of input FIFO 240 can be read enabled via the memory controller and clocked by clock signal 350. The input port of input FIFO 240 can be indirectly controlled by PHY controller 130, e.g., via signals 280 and 390, to write data out to input FIFO 240 responsive to received PHY control words from the memory controller. For example, PHY controller 130 can instruct, via signal 280, phaser in 225 to write enable the input port of input FIFO 240 via signal 390.

Input SERDES 215 deserializes data received from input buffer 340 from pin 380. Input buffer 340 conveys data to input SERDES 215 via signal 396. Input SERDES 215 outputs the resulting deserialized data to the input port of input FIFO 240 via signal 275. The input port of input FIFO 240 can receive data from input SERDES 215 through signal 275. The input port of input FIFO 240 can be clocked according to a clock signal at the SSD frequency that is generated by phaser in 225 and represented, at least in part, by signal 260. Phaser in 225 can regulate the input port of input FIFO 240, e.g., write enabling the input port, to control the flow of data into input FIFO 240 from input SERDES 215 via signal 390.

In one or more other embodiments, a data architecture similar to that of FIG. 3 can be implemented for a control path architecture within I/O bank 100. In such a configuration, the control path can utilize the architecture shown in FIG. 3, but exclude components such as input FIFO 240, phaser in 225, input SERDES 215 and input buffer 340.

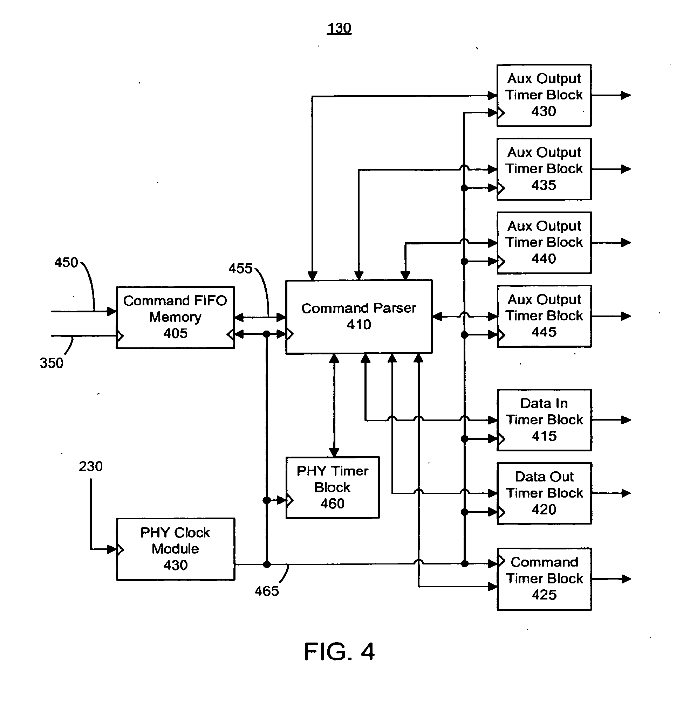

FIG. 4 is a fourth block diagram illustrating another aspect of an I/O bank in accordance with another embodiment. FIG. 4 illustrates an example of the PHY controller 130 in greater detail than illustrated with reference to FIGs. 1-3. As shown, PHY controller 130 can include a command FIFO memory 405, a command parser 410, a PHY clock module 430, and a plurality of timer blocks.

In general, PHY controller 130 can include two data timer blocks including a data in timer block 415 and a data out timer block 420, a command timer block 425, four auxiliary timers depicted as aux output timer blocks 430, 435, 440, and 445, and PHY timer block 460. It should be appreciated that each timer block illustrated within FIG. 4 can represent one or more, e.g., a plurality, of individual timers available for the purposes described within this specification.

Command FIFO memory 405 can be configured as an asynchronous FIFO having an input port and an output port. Command FIFO memory 405 provides a mechanism for crossing clock domains between that of the memory controller corresponding to the IC frequency and the memory device corresponding to the SSD frequency. The input port of command FIFO memory 405 can be coupled to the memory controller via signal 450 and can be clocked by clock signal 350 at the IC frequency. The second port of command FIFO memory 405 can be coupled to command parser 410 via signal 455 and is clocked at the SSD frequency via signal 465. Each other circuit element within FIG. 4 of PHY controller 130 is clocked at the SSD frequency by signal 465.

PHY clock module 430 can receive clock signal 230 at the SSD frequency as an input signal and generate one or more clock signals such as clock signal 465 as output. Clock signal 465 can be at approximately the SSD frequency to clock circuits operating at the same approximate speed as the memory device. Command FIFO memory 405 receives PHY control words sent from the memory controller via signal 450, which can be read according to clock signal 465. For purposes of illustration, signal 455 can represent the transfer of data from command FIFO memory 405 in addition to a read enable signal for the output port of command FIFO memory 405 controlled by command parser 410.

Command parser 410 reads PHY command words from command FIFO memory 405 and, in response to executing the PHY command words, writes particular timer values determined by virtue of the PHY command words executed into data in timer block 415, data out timer block 420, command timer block 425, aux output timer blocks 430-445, and/or PHY timer block 460. Command parser 410 can continuously read from command FIFO memory 405 as long as there are available timers, e.g., an available data timer and/or command timer. When all of the data and/or command timers are busy, e.g., no timer is available, command parser 410 can stop reading PHY command words from command FIFO memory 405. By discontinuing the reading of PHY command words, command parser 410 places back pressure on the memory controller which detects the full or filling state of command FIFO memory 405 so as to throttle the flow of commands.

In general, data in timer block 415, data out timer block 420, and/or command timer block 425 can control the management of data and commands going into and coming out from a byte clock group of an I/O bank by timing the relationships between command issuance and data availability. For example, command timer 425 can cause an event that sends a CAS strobe initiating a read event. Data in timer block 415 determines the number of clock cycles after the assertion of the CAS strobe when data is available at an output of the input SERDES and is available for transfer to a user. The timer event generated by data in timer block 415 indicates availability of the data. Thus, timers within data in timer block 415 and/or data out timer block 420 can generate events that indicate when to start or stop clocks and when to enable ports of one of the FIFOs. In this manner, data in timer block 415, data out timer block 420, and command timer block 425 can control the flow of data and commands. Aux output timer blocks 430-445 can include a plurality of timers configured to perform general purpose timing operations. Aux output timer blocks 430-445, for example, can be invoked by command parser 410 at the same time as a command associated with the timer is executed.

In one or more embodiments, the outputs from the timer blocks 415-445 can be multiplexed. Those circuit elements corresponding to data paths as illustrated with reference to FIG. 3, for example, can be coupled, via the multiplexers, to the data timer blocks 415, 420, and/or one of aux output timer blocks 430-445. The control signals from PHY controller 130 described with reference to FIG. 3 can be provided or output from the data in timer block 415 and/or data out timer block 420 as the case may be. Those circuit elements corresponding to command paths, for example, can be coupled to the command timer block 425. The control signals relating to commands can be provided or output from command timer block 425.

For example, referring again to FIG. 3 in combination with FIG. 4, data in timer block 415 can time the reception of data from an input SERDES. Data in timer block 415 further can manage the interface to a phaser in. When an active timer within data in timer block 415 reaches the terminal count, data in timer block 415 sends an "In_Burst_Pending" signal to the phaser in controlling the data path. The phaser in can generate the write enable signals and necessary clock signal to receive the data burst from the input SERDES. The phaser in further, in response, can write the data burst into the input FIFO. In conjunction with the "In_Burst_Pending" signal, data in timer block 415 also can send the current DDR Rank being read to the phaser in.

Data out timer block 420 can time when data is read from the output FIFO and transferred to the output SERDES. Data out timer block 420 can drive an "Out_Burst_Pending" signal high for one clock cycle at the frequency of the memory device for each DDR burst of data read from the output FIFO. The amount of data read from the output FIFO can be indicated by a "BURST_MODE" attribute. For example, the "BURST_MODE" attribute can be set high for a burst length of eight transactions and can be set low for a burst length of four transactions.

Command timer block 425 can be used to time when address and/or command information is read from an output FIFO configured to provide such address and/or command information to the memory. Command timer block 425 further can time when address and/or command information is transferred to the output SERDES. There is no need for control of the phasers or tri-state signals from command timer block 425. Only one nibble is read from an output FIFO for each command timer block 425 event.

PHY timer block 460 is a circuit block that can include one or more timers configured to control higher level functions and timing relationships. PHY timer block 460, unlike other timing blocks illustrated in FIG. 4, does not generate an outbound signal that is distributed outside of PHY controller 130. Rather, PHY timer block 460 communicates with command parser 410 to control different functions within PHY controller 130. In communicating with command parser 410, PHY timer block 460, for example, controls whether or not command parser 410 sends new timer events to other ones of timer blocks 415-445.

In this regard, PHY timer block 460 can cause an event, e.g., a timer event, to occur later in time than the occurrence of the command that initiates the timer event. Thus, the timer event originating from command parser 410 can be delayed under the control of PHY timer block 460. A timer event can remain active for a programmable duration referred to as the event duration under the control of PHY timer block 460. Aux output timer blocks 430-445 can generate signals to the memory device that do not occur at the exact time as data transfers or commands. The signals can be staggered. Aux output timer blocks 430-445 also can be used to implement "on-die termination" or "ODT" signals within an interface. For example, timers within PHY timer block 460 can be used to sequence continuous read and/or write commands such as those directed to a same column or general location within the memory device. In another example, timers within PHY timer block 460 also can be used to control spacing between commands issued to the memory device and the number of commands issued over a specified time period.

In further illustration of the functionality that can be achieved through PHY timer block 460, one or more timers within PHY timer block 460 can be used to implement row/bank timers. Row/bank timers enforce rules governing how a memory interface communicates with different banks or pages of a given memory device. For example, row/bank timers can control how close in time access to different banks can occur with respect to one another. In still another example, timers within PHY timer block 460 can control read/write or write/read turnaround. Read/write turnaround timers control how much time must separate a write command that follows a read command. Similarly, a write/read turnaround timer can control how much time must separate a read command that follows a write command.

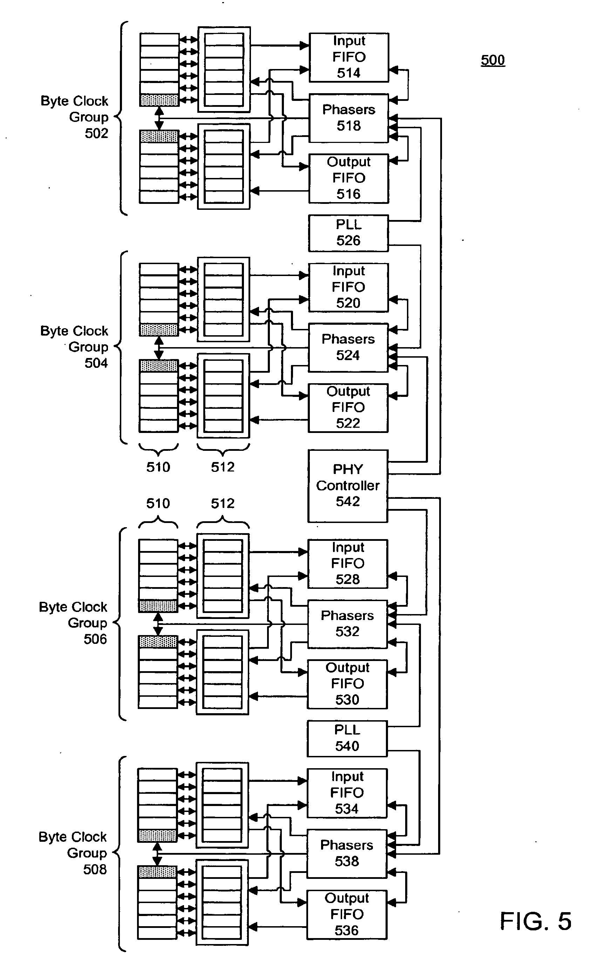

FIG. 5 is a fifth block diagram illustrating an I/O bank 500 in accordance with another embodiment disclosed within this specification. I/O bank 500 illustrates an exemplary I/O bank architecture that includes four byte clock groups 502, 504, 506, and 508. As illustrated, each of byte clock groups 502-508 includes 12 IOBs 510 and 12 IOIs 512. The IOBs 510 that can be reserved for use in receiving or sending strobe signals are illustrated with shading and further include direct connections to the particular phaser of the byte clock group within which the dedicated IOBs 510 are disposed.

Byte clock group 502 can include an input FIFO 514 and an output FIFO 516. For purposes of illustration, input phasers and output phasers are collectively represented by a single phaser block. Accordingly, byte clock group 502 can include phaser 518 that is dedicated to providing clock signals to input FIFO 514, output FIFO 516, the IOIs 512 within byte clock group 502, and the IOBs 510 within byte clock group 502. Byte clock group 504 can include an input FIFO 520 and an output FIFO 522. Accordingly, byte clock group 504 can include phaser 524 that is dedicated to providing clock signals to input FIFO 520, output FIFO 522, the IOIs 512 within byte clock group 504, and the IOBs 510 within byte clock group 504. PLL 526 can provide reference signals to each of phasers 518 and 524. Byte clock group 506 can include an input FIFO 528 and an output FIFO 530. Byte clock group 506 can include phaser 532 that is dedicated to providing clock signals to input FIFO 528, output FIFO 530, the IOIs 512 within byte clock group 506, and the IOBs 510 within byte clock group 506. Byte clock group 508 can include an input FIFO 534 and an output FIFO 536. Accordingly, byte clock group 508 can include phaser 538 that is dedicated to providing clock signals to input FIFO 534, output FIFO 536, the IOIs 512 within byte clock group 508, and the IOBs 510 within byte clock group 508. PLL 540 can provide reference signals to each of phasers 532 and 538.

Each of phasers 518, 524, 532, and 538 can be controlled by PHY controller 542. FIG. 5 illustrates an exemplary architecture in which the I/O circuitry, e.g., IOBs 510 and IOIs 512, are immediately adjacent to the various clock resources within I/O bank 500. It should be appreciated that I/O bank 500 can include additional clock resources (not shown) that typically available within an I/O bank such as global clock signals. The architecture shown in FIG. 5, however, illustrates that additional clock resources can be disposed within I/O bank for purposes of forming one or more source synchronous interfaces. Each of byte clock groups 502-508 can be configured independently to form one of four possible source synchronous interfaces with dedicated clock resources.

In an embodiment, I/O bank 100 can be incorporated into a scalable memory interface system for use within an IC that incorporates an asynchronous boundary between the control layer and the physical interface layer of the memory interface system. The memory interface system can include a memory controller and a physical interface block that can operate within separate and independent clock domains. For example, the memory controller can be configured to operate within one clock domain, while the physical interface block operates, in general, within a different clock domain. The clock domain of the physical interface block can operate at or about the same frequency at which the memory device to which the physical interface block is coupled. By placing an asynchronous clock boundary within the memory interface system, the operating frequency of the control layer can be maintained independently of the operating frequency of the physical layer and the memory device. Accordingly, the operating frequency of the control layer can be scaled as needed and matched with other system elements in communication with the control layer of the memory interface system.

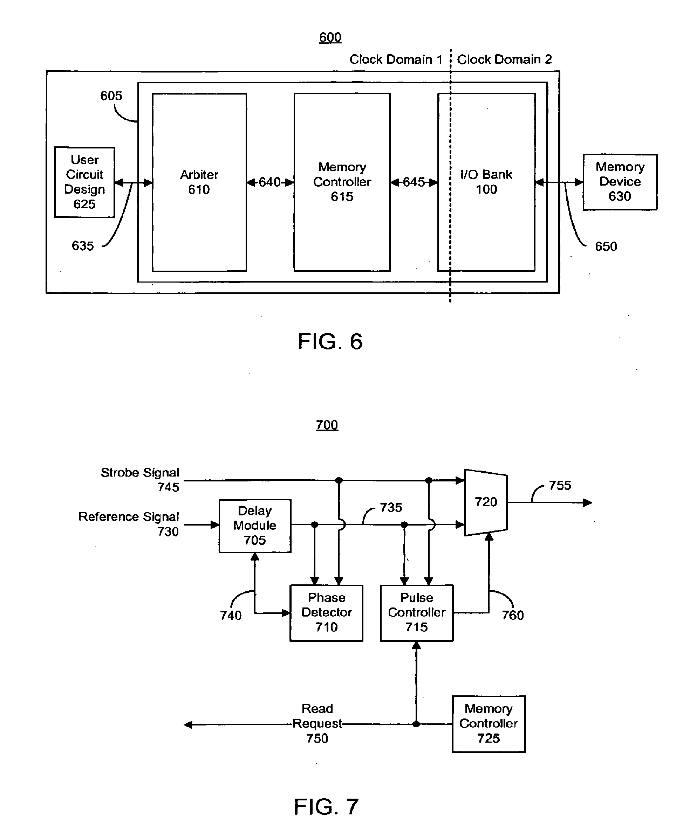

FIG. 6 is a sixth block diagram illustrating a memory interface system (system) 605 disposed within an IC 600 in accordance with another embodiment disclosed within this specification. System 605 can be implemented within IC 600 to facilitate communication with an SSD such as a memory device 630. As shown, system 605 can include an arbiter 610, a memory controller 615, and an I/O bank such as I/O bank 100. IC 600 can be implemented as a programmable IC or a non-programmable IC as previously described. The one or more embodiments disclosed herein are not intended to be limited to implementation or use within programmable ICs. Rather, IC 600 can be implemented as any of a variety of different IC types. For example, IC 600 can be implemented in the form of a processor having an embedded memory controller, an application specific IC, a mixed signal IC, or other type of non-programmable IC.

Memory device 630 can be implemented as any of a variety of DDR SDRAM devices. For example, memory device 630 can be implemented in the form of a DDR type of memory device, a DDR2 type of device, a DDR3 type of device, or a low power DDR (LPDDR or mobile DDR) type of device having a standard memory interface. Arbiter 610 can be coupled to a user circuit design 625 implemented within IC 600. Arbiter 610 can be coupled to user circuit design 625 via one or more channels 635. Arbiter 610 can monitor for user requests for access to memory device 630 made over channels 635. For example, arbiter 610, responsive to detecting one or more user requests for access to memory device 630, can determine channel prioritization. Responsive to determining user request priority, arbiter 610 can sub-divide the received user requests into one or more DDR access requests; order the DDR requests, and submit the DDR requests to memory controller 615 over signal 640.

Memory controller 615 can manage the flow of data going into and coming out of memory device 630. Memory controller 615 can generate the commands for writing data to, and reading data from, memory device 630. Memory controller 615 further can perform functions such as determining the order in which commands are executed by I/O bank 100. For example, memory controller 615 can reorder DDR requests received from arbiter 610 according to user designated channel priority so that requests received in one channel are given priority over another despite the existence of pre-existing requests from other channels.

Within this specification, the same reference characters are used to refer to terminals, signal lines, wires, and their corresponding signals. In this regard, the terms "signal," "wire," "connection," "terminal," and "pin" may be used interchangeably, from time-to-time, within the this specification. It also should be appreciated that the terms "signal," "wire," or the like can represent one or more signals, e.g., the conveyance of a single bit through a single wire or the conveyance of multiple parallel bits through multiple parallel wires. Further, each wire or signal may represent bi-directional communication between two or more components connected by a signal or wire as the case may be.

I/O bank 100 is coupled to memory controller 615 via signal 645 and to memory device 630 via signal 650. In general, I/O bank 100 implements an asynchronous boundary between clock domain 1 that can include memory controller 615 and arbiter 610 and clock domain 2 that can include the physical input/outputs (I/O) circuitry of IC 600 that couples to memory device 630, e.g., I/O bank 100. Accordingly, I/O bank 100 can communicate with memory device 630 at the full operating frequency supported by memory device 630 and communicate with memory controller 615 at a different and independent frequency. For example, memory controller 615 can operate at a frequency that is asynchronous to that of I/O bank 100 and, thus, memory device 630.

In accordance with one or more embodiments, I/O bank 100 implements a variety of real-time processing functions that typically are implemented by conventional memory controllers. By including real-time processing functions within I/O bank 100, memory controller 615 can operate at a different operating frequency than I/O bank 100 or memory device 630. For example, I/O bank 100 can perform a variety of clock signal generation, signal alignment, and transaction management functions ordinarily performed by memory controller 615. By relocating such functions within I/O bank 100, greater control over distortions on the clock lines can be achieved. Further, memory controller 615 can function at a higher level of abstraction. For example, memory controller 615 can perform data flow operations without regard for managing real time events to be described in greater detail within this specification.

As noted, IC 600 can be implemented as a programmable IC. In one or more embodiments where system 605 is implemented within a programmable IC, system 605 can be implemented using a combination of hardened circuits and "soft" circuits. In some cases, the programmable circuitry of a programmable IC operates at a frequency that is slower than a modern memory device. Using an asynchronous boundary as described within this specification allows elements such as arbiter 610 and memory controller 615 to be implemented using the programmable circuitry of a programmable IC. Thus, arbiter 610 and memory controller 615 can be implemented in the form of "soft circuits" that can operate at a clock rate that is slower than that of memory device 630. I/O bank 100, which communicates with memory device 630, can be implemented in the form of one or more hard circuit(s) that function at the operational frequency of memory device 630, e.g., faster than arbiter 610 and/or memory controller 615.

In operation, arbiter 610 can monitor for user requests received from user circuit design 625 over one or more of channels 635. Arbiter 610 can implement a selected arbitration scheme to fairly select and order user requests for processing by memory controller 615. One or more portions of user circuit design 625 and arbiter 610 can operate and, thus, communicate, at an operating frequency defining clock domain 1 and corresponding to one or more portions of user circuit design 625. Clock domain 1, and thus the operating frequency defining clock domain 1, can be referred to as the IC operating frequency.

Memory controller 615 can prioritize and reorder user requests received from arbiter 610 for efficient read/write access with respect to memory device 630. Memory controller 615 can reorder user requests independently of any order initially determined by arbiter 610. Memory controller 615, like arbiter 610, can operate at the IC frequency. Memory controller 615 can process the received user requests and issue one or more PHY control words to I/O bank 100 via signal 645 along with exchanging any data in support of reads and/or writes to memory device 630.

I/O bank 100 can receive the PHY control words from memory controller 615 for controlling access to memory device 630. I/O bank 100 can include one or more FIFO memories as described that support the sending of data and commands to memory device 630, the receipt of PHY control words from memory controller 615, and the receipt of data read from memory device 630. In general, the FIFO memories facilitate crossing between clock domain 1 and clock domain 2. Once data, commands, and PHY control words are clocked into the FIFO memories located within I/O bank 100, the remainder of I/O bank 100 can operate at a different operating frequency defining clock domain 2. Memory device 630 and the remaining portions of I/O bank 100 can operate at this different operating frequency referred to as the SSD frequency. Thus, channels 635 and signals 640 and 645 can be clocked at the IC frequency. Signal 650 coupling I/O bank 100 and memory device 630 can be clocked at the SSD frequency.

As discussed, the phaser block, e.g., phasers 135, can perform functions relating to management of a strobe signal to clock data into a system such as an IC. In this regard, a reference signal can be synchronized with a strobe signal received from an SSD sending data. When the pulses on the strobe signal terminate with the data, the reference signal can be propagated to one or more subsystems in lieu of the strobe signal. Providing the reference signal in lieu of the strobe signal allows the system to complete the clocking of received data into the destination subsystem(s). The reference signal effectively replaces the strobe signal to complete the capture and propagation of data received from the SSD.

To utilize the reference signal, the reference signal must be both phase and frequency aligned with the strobe signal. In one or more embodiments, a delay line can be used in combination with one or more frequency divider circuits. A high frequency reference signal can be used to generate a lower frequency reference signal that is phase and frequency aligned with the strobe signal. For example, the high frequency reference signal can have a frequency that is a given multiple higher than the strobe signal and, thus, the lower frequency reference signal.

The delay line can be configured to provide a maximum amount of delay that is approximately equal to the period of the high frequency reference signal. The frequency divider(s) can be configured to provide several different frequency divided signals, where each signal has a different phase. The phase difference between each frequency divided signal can be approximately equal to the period of the high frequency reference signal. While delays of up to a period of the high frequency reference signal can be achieved via the delay line, delays in excess of the period of the high frequency reference signal can be achieved by selecting a different frequency divided signal having a desired phase variance to output in combination with adjusting the amount of delay provided by the delay line. Using a delay line in combination with one or more frequency dividers requires less area than including the number and size of delay lines needed to operate over the same frequency range.

FIG. 7 is a seventh block diagram illustrating a system 700 for managing a strobe signal in accordance with another embodiment disclosed within this specification. System 700 can be implemented within an IC, e.g., a target, in the form of a phaser such as phaser 135 to facilitate communication with an SSD (source) such as a memory. For example, a source can include any of a variety of SDRAM devices. It should be appreciated, however, that while a memory is used within this specification for purposes of illustration, the one or more embodiments disclosed herein are not intended to be limited for use solely with a memory.

System 700 can include a delay module 705, a phase detector 710, a pulse controller 715, and a multiplexer 720. A memory controller 725 also can be included. Delay module 705 can receive a reference signal 730, e.g., a first reference signal, and can apply a selected amount of delay to reference signal 730 to generate and/or output a delayed version of reference signal 730 denoted as signal 735. Signal 735 also can be referred to as a second reference signal. The amount of delay applied to reference signal 730 by delay module 705 can be specified and/or determined by phase detector 710 via control signal 740.

Phase detector 710 can receive signal 735 and strobe signal 745 as inputs. Phase detector 710 can compare signal 735 with strobe signal 745 and measure the phase difference between the two signals. When phase detector 710 detects an edge of reference signal 735 occurring prior to a like edge of strobe signal 745, e.g., where "like" refers to both edges being rising or falling, phase detector 710 can instruct delay module 705 to increment an amount of delay applied to reference signal 735. When phase detector 710 detects an edge of reference signal 735 occurring after a like edge of strobe signal 745, phase detector 710 can instruct delay module 705 to decrement the amount of delay applied to reference signal 735.

When aligned, or substantially aligned, delay module 705 can, for example, toggle back and forth between incrementing the amount of delay and decrementing the amount of delay applied to signal 735. Thus, when the amount of delay stays relatively constant, e.g., continually cycling back and forth between two different amounts of delay, phase detector 710 can determine that signal 735 is phase and frequency aligned with strobe signal 745.

In one or more embodiments, reference signal 730 can have approximately a same frequency as strobe signal 745. In that case, delay module 705 can perform time shifting by adding or removing delay, for example, using a delay line. In one or more other embodiments to be described herein in greater detail, reference signal 730 can be set to a frequency that is higher than strobe signal 745. For example, reference signal 730 can have a frequency that is a multiple, e.g., two, four, or the like, times the frequency of strobe signal 745.

When reference signal 730 has a frequency that is a multiple of the frequency of strobe signal 745, delay module 705 can be configured to include a delay line and one or more frequency dividers. The delay line can be controlled to provide a variable amount of delay to reference signal 730 as specified by control signal 740. The frequency divider(s) bring the frequency of signal 735 down to that of strobe signal 745. Use of the higher frequency version of reference signal 730 in combination with frequency divider(s) and a delay line allows system 700 to achieve phase alignment with strobe signals over a larger frequency range while keeping the size of the delay line smaller than when using delay lines alone without frequency division.

Pulse controller 715 can include circuitry configured to perform several processing functions relating to strobe signal 745 and memory controller 725. In one aspect, pulse controller 715 can determine whether to pass signal 735 or strobe signal 745 through multiplexer 720 and instruct multiplexer 720 accordingly via control signal 760. In another aspect, pulse controller 715 can be configured to detect read requests, such as read request 750, issued by memory controller 725 to a source (not shown). Responsive to detecting read request 750, pulse controller 715 can determine various attributes of read request 750 such as the amount of data that is to be returned from the source. Pulse controller 715 further can determine whether read request 750 is part of a plurality of back-to-back read requests. For example, pulse controller 715 can monitor for issuance of subsequent read requests from memory controller 725 that occur within a predetermined period of time following read request 750. When a subsequent read request occurs within the predetermined period of time, the read requests are considered back-to-back.

In operation, memory controller 725 can issue read request 750 to the source, e.g., a memory. Read request 750 specifies the amount of data that is requested. Pulse controller 715 can detect read request 750 and determine the number of pulses expected on strobe signal 745 in response to read request 750 based, at least in part, upon the amount of data requested. For example, consider the case in which the source is a DDR type of SRAM. In that case, when read request 750 requests 4 bits of data, only two pulses are expected on strobe signal 745 since data is clocked on each edge of the pulses of strobe signal 745. Likewise, when 8 bits of data are requested by read request 750, pulse controller 715 determines that 4 pulses are expected on strobe signal 745.

As noted, when the data received from the source synchronous device stops, the pulses on strobe signal 745 that accompany the data also stop. As noted, in some cases a read request can be part of a plurality of back-to-back read requests. With regard to back-to-back read requests, the pulses on strobe signal 745 are continuous and only terminate with the last portion of data sent from the source in response to the last of the back-to-back read requests. When the pulses on strobe signal 745 stop, additional pulses can be required to clock the received data into additional circuitry of the IC within which system 700 is disposed.

For example, consider the case in which system 700 is disposed within a programmable IC. Additional pulses can be required to propagate any received data into additional circuitry such as the programmable fabric of the programmable IC. The received data from the source can be propagated into a deserializer and into a FIFO type of memory. From the FIFO memory, data can be propagated into the fabric of the programmable IC. Accordingly, additional pulses are needed to clock the received data through both the deserializer and the FIFO memory since the pulses on strobe signal 745 stop with the last bit of data sent from the SSD.

Phase detector 710 can measure the phase difference between signal 735 and strobe signal 745. As noted, signal 735 and strobe signal 745 can be approximately the same frequency. Phase detector 710 can instruct delay module 705 to increment the amount of delay or decrement the amount of delay applied to reference signal 730 until signal 735 is phase aligned with strobe signal 745 as described.

When data is received in response to read request 750, pulse controller 715 can instruct multiplexer 720 to pass strobe signal 745 as signal 755. Thus, initially, strobe signal 745 can be propagated to various subsystems, e.g., deserializer(s), FIFO memories, and the like, to clock data received with strobe signal 745. Pulse controller 715 can count pulses received in response to read request 750. When the expected number of pulses is received, e.g., the last pulse of the expected number of pulses is detected, pulse controller 715 instructs multiplexer 720 to pass signal 735 as signal 755 in lieu of strobe signal 745. Accordingly, strobe signal 745 is effectively replaced by signal 735. Thus, while pulses have stopped on strobe signal 745, additional pulses needed to continue propagating data received from the source are provided to the subsystems from signal 735.

In one or more embodiments, pulse controller 715 can be configured to allow a predetermined number of pulses from signal 735 to propagate as signal 755 before instructing multiplexer 720 to again pass strobe signal 745 as signal 755. In one or more other embodiments, pulse controller 715 can instruct multiplexer 720 to pass strobe signal 745 responsive to detecting a further, or subsequent, read request being issued from memory controller 725, e.g., a read request immediately following read request 750.

As noted, when a read request is part of a plurality of back-to-back read requests, further pulses are needed only after the last pulse corresponding to the last of the plurality of back-to-back read requests. Accordingly, pulse controller 715 can determine whether a read request is part of a plurality of back-to-back read requests and, if so, whether that read request is the last of the plurality of back-to-back read requests. The procedure to pass signal 735 in lieu of strobe signal 745 can be initiated when the last pulse is detected by pulse controller 715, e.g., whether a last pulse of an individual read request or a last pulse of a last of a plurality of back-to-back read requests.

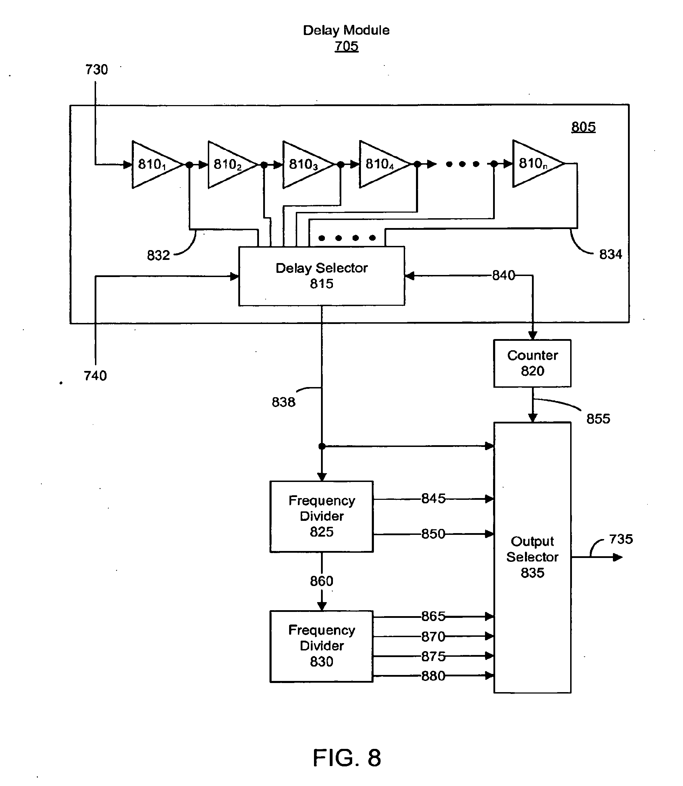

FIG. 8 is an eighth block diagram illustrating a system for delaying signals in accordance with another embodiment disclosed within this specification. More particularly, FIG. 8 illustrates an exemplary implementation of delay module 705 described with reference to FIG. 7. FIG. 8 illustrates an embodiment of delay module 705 in which reference signal 730 is set to a frequency that is higher than the frequency, e.g., a multiple of, the strobe signal. For example, the frequency of reference signal 730 can be one, two, three, four, etc., times the frequency of the strobe signal. In that case, a delay line can be used in combination with one or more frequency dividers as shown in FIG. 8. The frequency dividers facilitate generation of signal 735 at approximately the same frequency as the strobe signal. It should be appreciated, however, that in one or more other embodiments, reference signal 730 and the strobe signal can have approximately a same frequency. When reference signal 730 and the strobe signal have approximately a same frequency, frequency dividers are not needed. Rather, a delay line can be used to supply the entirety of the amount of delay needed to achieve phase alignment between signal 735 and the strobe signal.

Continuing with FIG. 8, delay module 705 can include a delay line 805, a counter 820, one or more frequency dividers 825 and 830, and an output selector 835. Delay line 805 can be implemented as a multi-tap delay line configured to provide a variable amount of delay to reference signal 730. As shown, delay line 805 can include a plurality of delay elements 810₁-810ₙ. Each of delay elements 810₁-810ₙ can provide a predetermined and/or approximately equivalent amount of delay. An output, also referred to as a tap, of each of delay elements 810₁-810ₙ can be coupled via a wire to delay selector 815.

Delay selector 815 can include circuitry that passes a particular tap, as specified by control signal 740, through as signal 838. In this manner, by selecting the particular delay element 810 from which the output of delay line 805 is taken, the amount of delay applied to reference signal 730 can be adjusted dynamically. Thus, as described with reference to FIG. 7, the phase detector can generate signal 740 for controlling delay selector 815 and, thus, the amount of delay applied to reference signal 730 by delay line 805.

For example, delay line 805 can include 64 taps, e.g., 64 different delay elements 810. Each of delay elements 810₁-810ₙ can be configured to provide an amount of delay approximately equal to the period of reference signal 730 divided by "n," where "n" is the total number of delay elements 810. Control signal 740, for example, can be configured to provide two different control signals including an increment signal and a decrement signal. Assertion of the increment signal as determined by the phase detector (not shown), adds a delay element 810 in the signal path of reference signal 730. Adding a delay element 810 also can be referred to as "increasing the delay by one tap." Assertion of the decrement signal as determined by the phase detector, removes a delay element 810 from the signal path of reference signal 730. Removing a delay element 810 also can be referred to as "decreasing the delay by one tap." The increment and decrement signals effectively select a particular tap that is passed by delay selector 815.

When the left-most signal, i.e., signal 832, is passed through delay selector 815 as signal 838, only a single delay element 810 is placed in the signal path of reference signal 730, thereby applying a minimum amount of delay available from delay line 805. The minimum amount of delay available from delay line 805 is approximately the period of reference signal 730 divided by the number of delay elements 810, i.e., "n." When the right-most signal, i.e., signal 834, is passed as signal 835, a maximum amount of delay available from delay line 805 is applied to reference signal 730. The maximum amount of delay available from delay line 805 is approximately a full period of reference signal 730.

In one or more embodiments, delay selector 815 can be configured to rollover in the forward and in the reverse directions. For example, when the maximum amount of delay available within delay line 805 is applied and control signal 740 indicates that the amount of delay is to be incremented, delay selector 815 rolls over from passing signal 834 to passing signal 832 corresponding to the minimum amount of delay available from delay line 805. Increasing the amount of delay applied to reference signal 730 when delay line 805 is already providing the maximum amount of delay can be referred to as a "forward rollover."

Similarly, when the minimum amount of delay available from delay line 805 is applied and control signal 740 indicates that the amount of delay is to be decremented, delay selector 815 rolls over from passing signal 832 to passing signal 834 corresponding to the maximum amount of delay available from delay line 805. Reducing the amount of delay applied to reference signal 730 when delay line 805 is already providing the minimum amount of delay can be referred to as a "reverse rollover."

Counter 820 is coupled to delay selector 815 via signal 840. Counter 820 can increment the value of the count stored therein when a delay element 810 is added to the signal path of reference signal 730. Counter 820 can decrement the value of the count stored therein when a delay element 810 is removed from the signal path of reference signal 730. In one or more embodiments, counter 820 can be configured to count up to "n," or from zero to "n-1," corresponding to the number of delay elements 810 within delay line 805. Accordingly, counter 820 can rollover in both the forward and reverse directions. Incrementing the counter beyond the highest value, e.g., "n," can cause a forward rollover where counter 820 rolls over, or resets, and continues to count up. Decrementing counter 820 when at zero, for example, can cause a reverse rollover where counter 820 rolls over in the reverse direction to the maximum count value and continues to count down. In any case, counter 820 can notify output selector 835 of a rollover, whether forward or reverse, and cause a different one of either signals 845 or 850 or 865, 870, 875, or 880 to be output as a result, i.e., signal 735.

Frequency divider 825 can be configured to divide the frequency of signal 838, e.g., the delayed version of reference signal 730, by two. As pictured, frequency divider 825 can generate signals 845 and 850 as output from received signal 838. Each of signals 845 and 850 can have a frequency of approximately one-half of the frequency of signal 838. Signal 845 can be phase aligned with signal 838, whereas signal 850 can be an inverted version of signal 845, i.e., 180 degrees out of phase.

In general, output selector 835 can be configured to operate in one of a plurality of modes. In a first mode, output selector 835 can be configured to output signal 838. The first mode of operation corresponds to one in which frequency division is not needed and signal 735 has a same frequency as that of the strobe signal. In a second mode, output selector 835 can be configured to output either signal 845 or signal 850 in response to control signal 855 from counter 820. The second mode can be used when reference signal 730 is approximately twice the frequency of the strobe signal. In a third mode, output selector 835 can be configured to pass either signal 865, 870, 875, or 880 responsive to control signal 855. The third mode can be used when reference signal 730 is approximately four times the frequency of the strobe signal.

Output selector 835 can be placed in the first mode, the second mode, or the third mode using any of a variety of techniques. For example, a control signal (not shown) can be provided to output selector 835 that places output selector 835 in either the first, second, or third mode. In another example, when the IC within which the system is disposed is a programmable IC, configuration data loaded into the programmable IC can specify the particular mode into which output selector 835 is to be placed.

As noted, delay line 805 can provide a full period of delay to reference signal 730. Turning to the case in which reference signal 730 has a frequency of approximately twice the strobe signal, it can be seen that delay line 805 provides only one-half of a period of delay to either of signals 845 and 850 since each of signals 845 and 850 has a frequency of approximately one-half of reference signal 730 and, therefore, twice the period. In order to achieve the remaining half period of delay that can be required for phase alignment of signal 735 with the strobe signal, e.g., when one of signals 845 or 850 is passed through output selector 835 as signal 735, counter 820 can be configured to instruct output selector 835 to pass signal 845 or signal 850 based upon whether the delay line rolls over.

In illustration, consider the case in which delay line 805 is applying a maximum amount of delay to reference signal 730 with delay selector 815 passing signal 834 as signal 838. Output selector 835 can be configured to initially pass signal 845 as signal 735. Thus, signal 838 is a version of reference signal 730 that is delayed by the maximum amount of delay available from delay line 805, i.e., one half of the period of either of signals 845 or 850. Signal 838 is frequency divided and can be output as signal 845, which can be passed through output selector 835 as signal 735. When control signal 740 instructs delay selector 815 to increment the amount of delay by adding a delay element 810, delay line 805 rolls over in the forward direction to provide the minimum amount of delay, e.g., passing signal 832 as signal 838. Counter 820 also rolls over in a forward direction and provides a notification of the forward rollover to output selector 835.

Responsive to an instruction from counter 820 via signal 855 indicating the forward rollover, output selector 835 passes signal 850 instead of signal 845. Recall that signal 850 is an inverted version of signal 845 and, therefore, is 180 degrees out of phase with signal 845. Thus, the amount of delay provided to signal 735, simply by passing signal 850 instead of 845, is approximately 180 degrees, e.g., one half of the period of reference signal 730. The rollover condition in delay line 805 causes the delay line to transition from providing the maximum amount of delay to providing the minimum amount of delay available.

The net delay applied in consequence of the forward rollover in delay line 805 and passing signal 850 instead of signal 845 results in a net increase in the delay of signal 735 of one tap, i.e., one delay element. Further increments per control signal 740 can be performed by again adding delay elements 810 to the signal path of reference signal 730. In this manner, up to a full period of delay (referring to signals 845 and 850) can be achieved despite delay line 805 providing only one-half of the delay needed.

A similar procedure can be performed in the opposite direction, e.g., when less delay is needed. For example, consider the case in which delay line 805 is applying a minimum amount of delay to reference signal 730 with delay selector 815 passing signal 832 as signal 838. Output selector 835 can be configured to initially pass signal 850 as signal 735. Thus, signal 838 is a version of reference signal 730 that is delayed by the minimum amount of delay available from delay line 805, i.e., one delay element 810. Signal 838 is frequency divided and can be output as signal 850, which can be passed through output selector 835 as signal 735. When control signal 740 instructs delay selector 815 to decrement the amount of delay by removing a delay element 810, delay line 805 rolls over in the reverse direction to provide the maximum amount of delay, e.g., passing signal 834 as signal 838. Counter 820 also rolls over in a reverse direction and provides a notification of the reverse rollover to output selector 835.

Responsive to an instruction from counter 820 via signal 855 indicating the reverse rollover, output selector 835 passes signal 845 instead of signal 850. Recall that signal 845 is an inverted version of signal 850 and, therefore, is 180 degrees out of phase with signal 850. Thus, the amount of delay provided to signal 735, simply by passing signal 845 instead of 850, is approximately 180 degrees, e.g., one half of the period of reference signal 730. The reverse rollover condition in delay line 805 causes the delay line to transition from providing the minimum amount of delay to providing the maximum amount of delay available. The net delay applied in consequence of the reverse rollover in delay line 805 and passing signal 845 instead of signal 850 results in a net reduction in the delay of signal 735 of one tap, i.e., one delay element. Further reductions per control signal 740 can be performed by again removing delay elements 810 from the signal path of reference signal 730.

The combination of delay line 805 with frequency divider 825 illustrates one way in which delays greater than that available solely through delay line 805 can be achieved when a reference frequency that is higher than the frequency of the strobe signal is used. Through the addition of frequency divider 830, even greater flexibility can be attained.

Frequency divider 830 can receive an output signal 860 from frequency divider 825. Signal 860 has a frequency of approximately one-half of the frequency of reference signal 730. Accordingly, frequency divider 830 generates signals 865-880, each having a frequency of approximately one-fourth of the frequency of reference signal 730. In one or more embodiments, signal 865 can have a phase substantially equal to that of signal 860. Each of signals 865-880 can have a phase variance of approximately 90 degrees with respect to one another. For example, the phase of signal 870 can be approximately 90 degrees ahead of the phase of signal 865. The phase of signal 875 can be approximately 90 degrees ahead of the phase of signal 870. The phase of signal 880 can be approximately 90 degrees ahead of the phase of signal 875.

Output selector 835 can be configured to output, e.g., pass, one of signals 865-880 as signal 735 depending upon when counter 820 rolls over and the direction of the rollover, i.e., forward or reverse. With each of signals 865-880 having a frequency of approximately one-fourth of the frequency of reference signal 730, it can be appreciated that delay line 805 provides at most, one-fourth of the period of signals 865-880 in terms of delay. Thus, counter 820 can be used to determine whether delay selector 815 crosses quarter period boundaries, e.g., moves from passing signal 832 to 834 or from passing 834 to signal 832.

In illustration, a transition from passing signal 834 to signal 832, i.e., a forward rollover, causes counter 820 to instruct output selector 835 to pass a signal having a phase variance 90 degrees ahead of the current signal being passed. For example, when signal 865 is passed when a forward rollover occurs, output selector 835 passes signal 870 in lieu of signal 865. Likewise, a transition from passing signal 832 to signal 834, i.e., a reverse rollover, causes counter 820 to instruct output selector 835 to pass a signal having a phase variance 90 degrees behind the current signal being passed. For example, if signal 870 is passed when a reverse rollover occurs, output selector 835 passes signal 865 in lieu of signal 870. By selecting one of signals 865-880 combined with varying amounts of delay applied by delay line 805, signal 735 can have an adjustable delay ranging from approximately the delay provided by a single delay element 810 to an amount of delay that is approximately four times the period of reference signal 730, i.e., one full period of a signal such as signal 865.

Additional strobe signal processing functions can include dynamic detection of a strobe signal within an IC. A timing relationship can be determined between a control signal and a first pulse of a strobe signal. More particularly, a control signal can be sent from a target to an SSD. Responsive to the control signal, the SSD can begin specifying a reference signal via the strobe signal. The first pulse, for example, on the strobe signal can be detected.

The time that is measured between the control signal and the first pulse can be used to squelch the strobe signal in subsequent transactions. Accordingly, the strobe signal is effectively gated, using the measured timing relationship, from a time indicated by the control signal to approximately the time when the strobe signal transitions to specifying a reliable reference signal that is usable by the target system communicating with the source synchronous device.

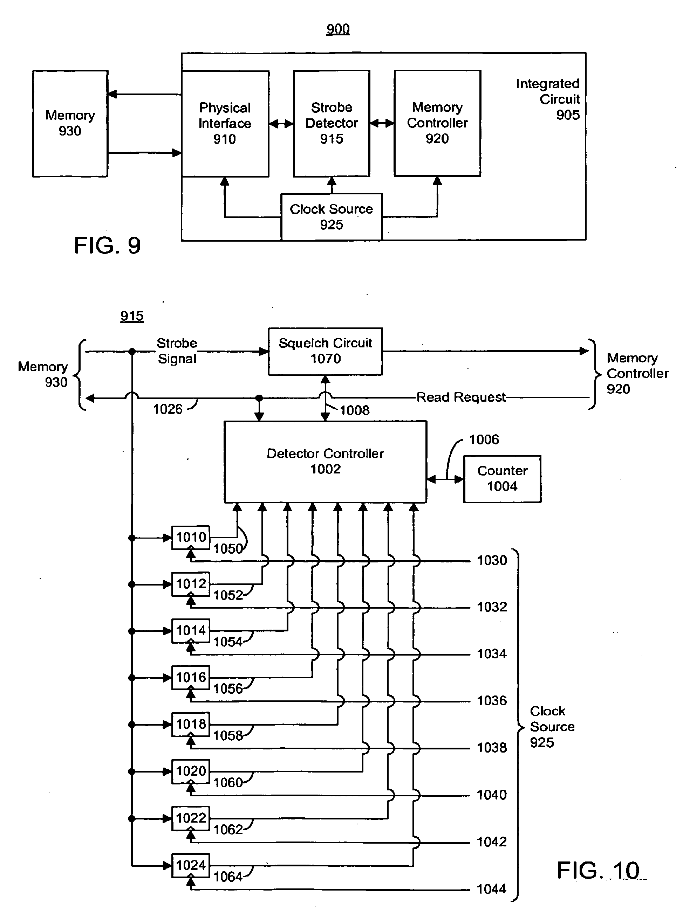

FIG. 9 is a ninth block diagram illustrating a system 900 for processing a strobe signal in accordance with another embodiment disclosed within this specification. FIG. 9 illustrates an IC 905 communicating with an SSD such as a memory 930. For example, memory 930 can be implemented as any of a variety of SDRAM devices. It should be appreciated that a memory is used within this specification for purposes of illustration. The one or more embodiments disclosed within this specification can be applied to any of a variety of different SSD and are not limited to use with a memory.

As shown, IC 905 can include a physical interface 910, e.g., I/O bank 100, a strobe detector 915, a memory controller 920, and clock source 925. Physical interface 910 can include circuitry such as input/output (I/O) blocks, pins, and the like through which the signals passed between IC 905 and memory 930 are propagated.

Strobe detector 915 can perform a variety of functions relating to alignment and/or detection of signals to facilitate communication between memory controller 920 and memory 930. In one or more embodiments, strobe detector 915 can detect when a read request is initiated, e.g., sent, from memory controller 920 and directed to memory 930. Strobe detector 915 can determine an amount of time between the sending, or initiation, of the read request and the transitioning of the strobe signal from a tri-stated state to one in which a valid reference signal is specified. The strobe signal can be a data strobe signal, also referred to as a DQS signal.

Memory controller 920 can include circuitry configured to read from, and write to, memory 930. For example, when memory 930 is implemented as a DRAM, memory controller 920 can communicate with memory 930 to read from memory 930 or write to memory 930. In that case, memory controller 920 further can include circuitry to "refresh" memory 930 by providing current or power to memory 930.

Clock source 925 can include circuitry configured to generate clock signals that are distributed to each of physical interface 910, strobe detector 915, and memory controller 920. For example, strobe detector 915 can utilize a plurality of different clock signals, where each is phase adjusted to achieve oversampling of a selected signal such as the strobe signal from memory 930. Clock source 925 can generate the requisite clock signals needed by strobe detector 915 to oversample the strobe signal as will be described in greater detail within this specification with reference to the remaining figures. Clock source 925 further can generate the clock signals necessary to drive physical interface 910 and memory controller 920. Clock source 925 can generate the needed signals from one or more received reference clock signal(s) or generate the needed clock signals internally.

In operation, memory controller 920 can initiate a read request that is sent to memory 930 via physical interface 910. In one or more embodiments, the read request can be propagated through strobe detector 915. For example, responsive to receiving the read request from memory controller 920, strobe detector 915 can forward the read request to physical interface 910. In one or more other embodiments, memory controller 920 can send the read request directly to physical interface 910 and provide a copy of the read request to strobe detector 915.

Responsive to determining that a read request has been initiated or sent by memory controller 920, strobe detector 915 can begin monitoring for the occurrence of a first pulse on the strobe signal received from memory 930. In general, when not in use, memory 930 keeps the strobe signal tri-stated. The strobe signal remains in a high impedance state, or "high z" state, until responding to a request, for example, from memory controller 920. Responsive to the read request, memory 930 can generate and send a preamble on the strobe signal. In one embodiment, the preamble can be defined as pulling the voltage of the strobe signal low for one, or approximately one, clock cycle at the frequency of the reference to be provided by the strobe signal. After the preamble, the strobe signal specifies a first pulse of a series of pulses that form the reference signal to be used by memory controller 920 in reading data received from memory 930.

Strobe detector 915 can be configured to detect the first pulse following the preamble of the strobe signal and, thus, calculate the amount of time between the read request and the detection of the first pulse. The amount of time is the "round-trip" time between when the read request is sent to memory 930 and the strobe signal from memory 930 begins providing the needed reference signal for acquisition and processing of data from memory 930. Since the strobe signal is tri-stated when the read request is issued, the strobe signal should be prevented from entering systems of IC 905 until the strobe signal has transitioned to providing a reliable reference signal. Thus, the strobe signal can be gated from the time the read request is sent until approximately the first pulse is received following the preamble. In general, strobe detector 915 can squelch, e.g., suppress, the strobe signal responsive to detecting the read request and stop gating the strobe signal after the measured amount of time has passed, e.g., the amount of time between a prior read request and the first pulse following the prior read request. Gating can be performed using prior measured values in a prospective manner. For example, the amount of time between the read request and the first pulse following the read request can be determined responsive to each read request. The amount of time calculated responsive to each read request can be used in squelching the strobe signal for the following, or subsequent, read request. Thus, the duration of the squelching performed by strobe detector 915 can be continually updated to account for changes in the timing of the strobe signal that can result from variation in temperature and/or voltage.

In one or more embodiments, strobe detector 915 can be incorporated within physical interface 910. For example, strobe detector 915 can be disposed within an I/O bank of IC 905. In another example, strobe detector 915 can be implemented within, or as part of, a phaser such as phaser 135 as previously described. In one or more other embodiments, clock source 925 also can be disposed with physical interface 910. For example, clock source 925 can be disposed within an I/O bank of IC 905.

FIG. 10 is a second block diagram illustrating a strobe detector in accordance with another embodiment. More particularly, FIG. 10 illustrates strobe detector 915 described with reference to FIG. 1. As shown, strobe detector 915 can include a detector controller 1002, a counter 1004, a plurality of sampling flip-flops (FFs) 1010-1024, and a squelch circuit 1070.

Detector controller 1002 is coupled to counter 1004 via signal 1006. Through signal 1006, detector controller 1002 can start counter 1004, stop counter 1004, read the counter value stored within counter 1004, and/or reset counter 1004. In one or more embodiments, counter 1004 can be configured to operate at approximately eight times the frequency of the signal being monitored, which is the strobe signal in this case. Accordingly, counter 1004 can increment the counter value stored therein by one for every one-eighth of a clock cycle of the strobe signal that passes. It should be appreciated that while the strobe signal does not provide a constant reference signal, any reference to the frequency or clock period of the strobe signal refers to the frequency and/or clock period of the strobe signal when a valid reference signal is specified following the preamble, for example.

Detector controller 1002 is also coupled to squelch circuit 1070 via signal 1008. Squelch circuit 1070 is configured to squelch the strobe signal for a predetermined amount of time. For example, squelch circuit 1070 can gate the strobe signal for an amount of time determined by the counter value from counter 1004 as determined by controller 1002. As noted, the strobe signal can be a DQS signal. Thus, squelch circuit 1070 can pass a static value, whether configured to be a low static signal or a high static signal, to memory controller 920 while the strobe signal is gated.

Sampling FFs 1010-1024 can be clocked by clock signals 1030-1044 respectively. Clock signals 1030-1044 can be generated, or provided, by clock source 925. Sampling FFs 1010-1024 can output signals 1050-1064, respectively, to detector controller 1002. Clock signals 1030-1044 can have approximately a same frequency as the strobe signal. While the frequency of each of clock signals 1030-1044 can be substantially the same or similar, the phase of each of clock signals 1030-1044 can be staggered or different.

For purposes of illustration, consider the phase of clock signal 1030 to be a baseline phase from which the phase of each of clock signals 1032-1044 can be varied or adjusted. For example, denoting the phase of clock signal 1030 to be "0," the phase of clock signal 1032 can be "θ + N," where N is a predetermined value. The phase of clock signal 1034 can be "θ + 2N." The phase of clock signals 1036-1044 can be "θ + 3N," "θ + 4N," "θ + 5N," "θ + 6N," and "θ + 7N," respectively. In one or more embodiments, N can be selected to be an integer value. The value of N can be determined, for example, by dividing 360 degrees by the number of sampling FFs used to sample the strobe signal. Referring to FIG. 10, the value of N can be determined to be "360/8," which is 45 degrees. Accordingly, a phase variance of approximately 45 degrees exists between each of the clock signal pairs 1030-1032, 1032-1034, 1034-1036, 1036-1038, 1038-1040, 1040-1042, and 1042-1044.

Thus, sampling FF 1012 captures the value of the strobe signal approximately one-eighth of the strobe signal clock cycle after sampling FF 1010. Sampling FF 1014 captures the value of the strobe signal approximately one-eighth of the strobe signal clock cycle after sampling FF 1012, and so on. Detector controller 1002, by monitoring each of signals 1050-1064 from sampling FFs 1010-1024, respectively, determines the state of the strobe signal at intervals of one-eighth of the clock cycle of the strobe signal, effectively achieving eight times oversampling of the strobe signal.

As pictured in FIG. 10, signal 1026 can be generated from memory controller 920 and provided to memory 930. Signal 1026 can be coupled to detector controller 1002. Detector controller 1002 can monitor signal 1026 and detect when a read request is issued by memory controller 920 to memory 930. Responsive to detecting the read request on signal 1026, detector controller 1002 can start counter 1004. As discussed, the strobe signal is placed in a "high z state" or tri-stated until exercised by memory 930 when data is to be sent to memory controller 920. The strobe signal can be tri-stated, for example, up to the time when memory 930 sends the preamble. Detector controller 1002 can, via sampling FFs 1010-1024, sample the strobe signal at varying times to detect the preamble and the first pulse following the preamble that is sent from memory 930 in response to the read request from memory controller 920.

Detector controller 1002 can start counter 1004 responsive to the read request on signal 1026 and allow counter 1004 to continue running, e.g., counting, until such time that a predetermined bit pattern is detected by sampling the strobe signal using sampling FFs 1010-1024 collectively. As shown, the strobe signal is provided as input to each of sampling FFs 1010-1024. In one or more embodiments, oversampling of the strobe signal can be initiated responsive to detecting the read request. In one or more other embodiments, however, oversampling of the strobe signal can be performed continually, with detector controller 1002 ignoring sampled values of the strobe signal when a read request has not been detected from memory controller 920.

In any case, detector controller 1002 can monitor the sampled values of the strobe signal via signals 1050-1064 for the occurrence of a predetermined bit pattern. For example, the predetermined bit pattern can be 000011, 0000011, 00000011, or the like. The particular bit pattern can vary according to the amount of oversampling achieved and the frequency of the strobe signal. The plurality of detected zero values followed by one or more one values indicates the detection of the.rising edge of the first pulse immediately following the preamble within the strobe signal. Detector controller 1002 can evaluate the values from each of signals 1050-1064 as a serial stream of bits. For example, detector controller 1002 can read sampled bit values specified by signals 1050, 1052, 1054, 1056, 1058, 1060, 1062, and 1064 sequentially, and then repeat to form a continuous stream of sampled bit values.

Subsequent to the preamble, the strobe signal can begin oscillating, e.g., providing a reference signal. In one or more embodiments, the strobe signal, following the preamble, can have approximately a 50-50 duty cycle. Responsive to detecting the predetermined bit pattern, detector controller 1002 can determine the counter value within counter 1004 via signal 1006. For example, counter 1004 can be stopped responsive to detection of a rising edge of the strobe signal. The counter value can be read and stored within a register in detector controller 1002. Detector controller 1002 then can clear counter 1004.

Recalling that the strobe signal is initially tri-stated prior to issuance of the read request, detector controller 1002 can, in some cases, detect a false positive. More particularly, detector controller 1002 can detect the predetermined bit pattern due to noise or a condition other than the occurrence of the first pulse following the preamble on the strobe signal. For example, since the strobe signal is initially in a high z state, the value sampled for the strobe signal can be random and result in a random pattern being detected within the stream of bits that can match the predetermined bit pattern.

To avoid a false positive, detector controller 1002 oversamples the strobe signal and can monitor for the last detected instance or occurrence of the predetermined bit pattern prior to determining that the strobe signal has started oscillating as a valid reference signal. In general, once the strobe signal starts specifying a valid reference signal following the preamble, the duty cycle can be fixed, e.g., be 50-50. Detector controller 1002 can distinguish the pattern generated from oversampling the strobe signal with a 50-50 duty cycle from the predetermined bit pattern indicative of the first pulse following the preamble. For example, a 50-50 duty cycle can be detected by detector controller 1002 by recognizing that subsequent to the predetermined bit pattern, approximately four ones occur followed by approximately four zeros, with a repeating pattern of approximately four ones followed by four zeros corresponding to a 50-50 duty cycle reference signal.

The counter value determined by detector controller 1002, as noted, can be stored for use in a subsequent read transaction. More particularly, the counter value can be stored within, or otherwise provided to, squelch circuit 1070. Responsive to a next read request, detector controller 1002 can instruct squelch circuit 1070 to squelch the strobe signal for the amount of time specified by the counter value provided, e.g., the counter value determined responsive to the prior read request. Thus, the amount of time that the strobe signal is squelched, or gated, can be updated responsive to each read request. The updated amount of time, as specified by the counter value, can be used by the squelch circuit prospectively, i.e., responsive to a next read request.

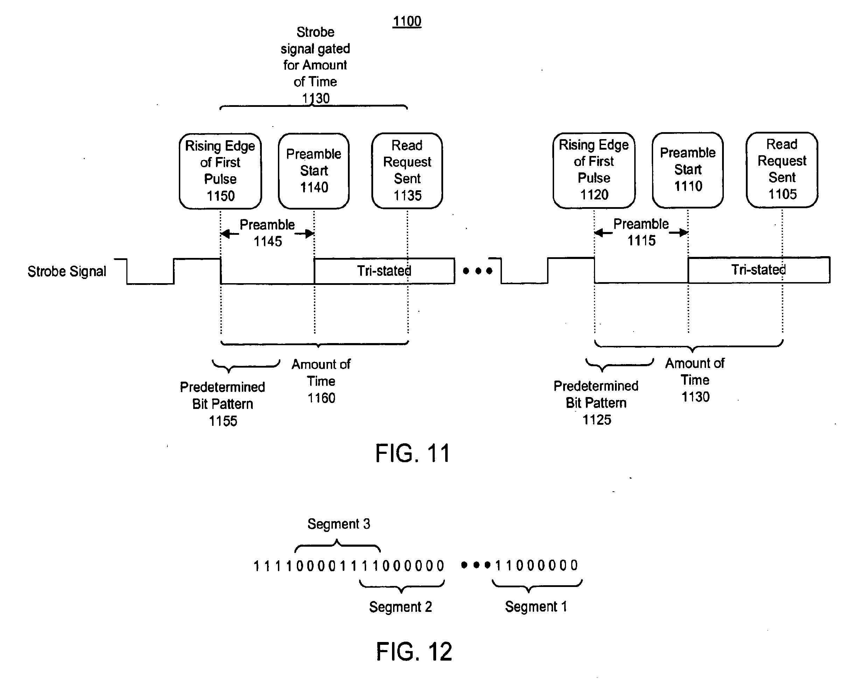

FIG. 11 is a signal diagram 1100 illustrating different states of the strobe signal.that can be detected and/or measured in accordance with another embodiment disclosed within this specification. As shown, FIG. 11 illustrates that the strobe signal is initially tri-stated when a read request 1105 is sent from the memory controller. The strobe detector starts the counter and sampling of the strobe signal. Responsive to receiving read request 1105, the memory pulls the strobe signal low to specify preamble 1115 as illustrated by preamble start 1110. The rising edge of the first pulse 1120 indicates the end of preamble 1115. The strobe detector detects the rising edge of the first pulse 1120 by observing a last instance or occurrence of the predetermined bit pattern 1125 prior to observing the strobe signal transitioning from preamble 1115 to approximately a 50-50 duty cycle. The strobe detector reads or otherwise determines the counter value responsive to detecting the rising edge of the first pulse 1120 following preamble 1115 to determine the amount of time 1130.

Subsequent to the read operation, the strobe signal again is tri-stated and remains tri-stated when a subsequent read request 1135 is sent from the memory controller. The strobe detector can again start the counter, which can be first reset, and sample the strobe signal. Responsive to receiving read request 1135, the memory can pull the strobe signal low to specify preamble 1145 as illustrated by preamble start 1140. The rising edge of the first pulse 1150 indicates the end of preamble 1145. The strobe detector detects the rising edge of the first pulse 1150 by observing a last instance or occurrence of the predetermined bit pattern 1155 prior to observing the strobe signal transitioning from preamble 1145 to approximately a 50-50 duty cycle. The strobe detector reads or otherwise determines the counter value responsive to detecting the rising edge of the first pulse 1150 following preamble 1145 to determine the amount of time 1160 for use in gating or squelching the strobe signal responsive to a further read request (not shown).

As noted, the amount of time 1130, as determined from the read request 1105, is used to gate the strobe signal responsive to read request 1135. The amount of time 1130 is an approximation of the actual time that the strobe signal should be gated responsive to read request 1135, i.e., amount of time 1160. By continually updating the counter value responsive to each read request, variation in signal timing, e.g., drift in the strobe signal, due to voltage and temperature effects in the system can be reduced and/or minimized.

FIG. 12 is an example of a stream of bits determined by oversampling the strobe signal in accordance with another embodiment disclosed within this specification. FIG. 12 illustrates an example of different artifacts and state transitions that can be detected by the strobe detector as described with reference to FIGs. 9-11 of this specification. Segment 1 illustrates an example of a false positive where the predetermined bit pattern is detected not in consequence of the rising edge of the first pulse following the preamble, but rather in consequence of noise, tri-stating of the strobe signal, or some other artifact that manifests itself on the strobe signal. Segment 2, which also corresponds to the predetermined bit pattern, does indicate the occurrence of the rising edge of the first pulse following the preamble on the strobe signal. Segment 2 can be distinguished from a false positive due to segment 3, which corresponds to a bit pattern that identifies a duty cycle of approximately 50-50, indicating that the strobe signal has transitioned to specifying a valid reference signal. Accordingly, the strobe detector determines that segment 2, being immediately followed by a bit pattern indicating a reference signal, is not a false positive as distinguished from segment 1.

The figures illustrate the architecture, functionality, and operation of possible implementations of systems and methods according to various embodiments. It should be noted that, in some alternative implementations, the functions noted in the blocks may occur out of the order noted in the figures. For example, two blocks shown in succession may, in fact, be executed substantially concurrently, or the blocks may sometimes be executed in the reverse order, depending upon the functionality involved.

Embodiments can be realized in hardware or a combination of hardware and software. The embodiments can be realized in a centralized fashion in one system or in a distributed fashion where different elements are spread across several interconnected systems. Any kind of data processing system or other apparatus adapted for carrying out the methods described herein is suited.

The terms "a" and "an," as used herein, are defined as one or more than one. The term "plurality," as used herein, is defined as two or more than two. The term "another," as used herein, is defined as at least a second or more. The terms "including" and/or "having," as used herein, are defined as comprising, i.e., open language. The term "coupled," as used herein, is defined as connected, whether directly without any intervening elements or indirectly with one or more intervening elements, unless otherwise indicated. Two elements also can be coupled mechanically, electrically, or communicatively linked through a communication channel, pathway, network, or system.

## Claims

1. An integrated circuit, comprising:
an input/output also called I/O bank (100) comprising a plurality of byte clock groups (200);
wherein each of the plurality of byte clock groups comprises a phaser (135) configured to clock circuit elements of the byte clock group at a frequency at which a source synchronous device coupled to the byte clock group communicates data;
wherein each byte clock group further comprises:
an output first-in-first-out also called FIFO memory (235) within the I/O bank comprising at least two asynchronously clocked ports, wherein an input port of the output FIFO memory is clocked at a first operating frequency and an output port of the output FIFO is clocked by the phaser at a second operating frequency higher than the first operating frequency corresponding to the source synchronous device; and
an input FIFO memory (240) within the I/O bank comprising at least two asynchronously clocked ports, wherein an output port of the input FIFO memory is clocked at the first operating frequency and an input port of the input FIFO memory is clocked by the phaser at the second operating frequency;
a plurality of input serializer/deserializers also called SERDES (215) within the I/O bank configured to deserialize data received from the source synchronous device and provide the deserialized data to the input port of the input FIFO memory; and
a plurality of output SERDES (210) within the I/O bank configured to serialize data received from the output port of the output FIFO memory to be output to the source synchronous device,
wherein the phaser within each of the plurality of byte clock groups is configured to provide clock signals at the second operating frequency to each of the plurality of input SERDES and each of the plurality of output SERDES of the byte clock group.

2. The integrated circuit of claim 1, wherein the phaser of each of the plurality of byte clock groups is independently configurable.

3. The integrated circuit of any one of claims 1-2, wherein the I/O bank further comprises:
a physical interface controller configured to coordinate operation of each phaser of each of the plurality of byte clock groups,
wherein the physical interface controller comprises a plurality of timers that specify when, for each byte clock group, the phaser of the byte clock group clocks data out from the output FIFO memory and clocks data into the input FIFO memory.

4. The integrated circuit of any one of claims 1-3, further comprising:
a memory controller configured to operate at the first operating frequency,
wherein the I/O bank is coupled to the memory controller,
wherein the I/O bank is configured to communicate with the memory controller at the first operating frequency and communicate with a memory device at the second operating frequency.

5. The integrated circuit of any one of claims 1-4, wherein the phaser further comprises:
a pulse controller configured to count pulses from the source synchronous device received in a strobe signal responsive to a first read request, wherein the pulse controller is configured to detect a last pulse of a predetermined number of expected pulses; and
a multiplexer coupled to the pulse controller and configured to selectively pass the strobe signal or a reference signal responsive to an instruction received from the pulse controller, wherein the reference signal is phase and frequency aligned with the strobe signal,
wherein responsive to the pulse controller detecting the last pulse, the pulse controller is configured to instruct the multiplexer to pass the reference signal in lieu of the strobe signal.

6. The integrated circuit of any one of claims 1-5, wherein the phaser further comprises:
a delay line configured to apply an amount of delay to a reference signal;
at least one frequency divider coupled to the delay line and configured to generate a first frequency divided signal and a second frequency divided signal from a version of the reference signal output from the delay line, wherein the first and the second frequency divided signals have a same frequency and a different phase;
a phase detector configured to determine a phase relationship between a strobe signal and at least one of the first frequency divided signal or the second frequency divided signal; and
an output selector coupled to the at least one frequency divider, wherein the output selector is configured to pass the first frequency divided signal or the second frequency divided signal according to a counter that indicates adjustments in the amount of delay applied by the delay line,
wherein the delay line adjusts the amount of delay applied to the reference signal responsive to the phase relationship determined by the phase detector, and
wherein responsive to the delay line rolling over, the second frequency divided signal is.output.

7. The integrated circuit of any one of claims 1-6, wherein the phaser further comprises:
a plurality of sampling flip-flops oversampling a strobe signal, wherein each of the plurality of sampling flip-flops is clocked by a clock signal having a different phase and approximately a same frequency as a frequency of the strobe signal;
a controller configured to detect a read request sent to the source synchronous device and determine an amount of time between the read request and a first pulse of the strobe signal according to values received from the plurality of sampling flip-flops oversampling the strobe signal; and
a squelch circuit configured to gate the strobe signal for the amount of time responsive to a subsequent read request.

8. A method of operation for an integrated circuit also called IC, the method comprising:
defining a plurality of byte clock groups (200) within an input/output also called I/O bank (100) of the IC, wherein each byte clock group comprises a phaser (135);
clocking circuit elements of each byte clock group using the phaser of the byte clock group at a frequency at which a source synchronous device coupled to the byte clock group communicates;
deserializing data received from the source synchronous device within a byte clock group of the plurality of byte clock groups;
serializing data to be output to the source synchronous device within the byte clock group of the plurality of byte clock groups; and
for each byte clock group, providing from the phaser within the byte clock group:
clock signals for the deserializing and the serializing at the frequency of the source synchronous device;
a clock signal for clocking an output port of an output first-in-first-out also called FIFO memory (235) located in the I/O bank in the byte clock group comprising at least two asynchronously clocked ports; and
a clock signal for clocking an input port of an input FIFO memory (240) located in the I/O bank in the byte clock group comprising at least two asynchronously clocked ports;
wherein an input port of the output FIFO memory and an output port of the input FIFO memory each is clocked at a different frequency lower than the frequency of the source synchronous device.

9. The method of claim 8, further comprising:
operating a memory controller at a first operating frequency, wherein the I/O bank is coupled to the memory controller, and
the I/O bank communicating with the memory controller at the first operating frequency and communicating with a memory device at a second operating frequency;
wherein the first operating frequency is the different frequency lower than the frequency of the source synchronous device and the second operating frequency is the frequency of the source synchronous device.

10. The method of claims 8 or 9, further comprising:
counting pulses from the source synchronous device received in a strobe signal responsive to a first read request;
detecting a last pulse of a predetermined number of expected pulses; and
passing a reference signal in lieu of the strobe signal responsive detecting the last pulse, wherein the reference signal is phase and frequency aligned with the strobe signal.

11. The method of any one of claims 8-10, further comprising:
applying an amount of delay to a reference signal;
generating a first frequency divided signal and a second frequency divided signal from a version of the reference to which the amount of delay is applied, wherein the first and the second frequency divided signals have a same frequency and a different phase;
determining a phase relationship between a strobe signal and at least one of the first frequency divided signal or the second frequency divided signal;
adjusting the amount of delay applied to the reference signal responsive to the phase relationship;
passing the first frequency divided signal or the second frequency divided signal according to a counter that indicates the amount of delay applied to the reference signal; and
responsive to the amount of delay rolling over, outputting the second frequency divided signal.

12. The method of any one of claims 8-11, further comprising:
oversampling a strobe signal using a plurality of sampling flip-flops, wherein each of the plurality of sampling flip-flops is clocked by a clock signal having a different phase and approximately a same frequency as a frequency of the strobe signal;
detecting a read request sent to the source synchronous device;
determining an amount of time between the read request and a first pulse of the strobe signal according to values received from the plurality of sampling flip-flops oversampling the strobe signal; and
squelching the strobe signal for the amount of time responsive to a subsequent read request.

## Patentansprüche

1. Integrierte Schaltung, Folgendes umfassend:
eine Eingangs/Ausgangs-Bank, auch E/A-Bank (100) genannt, die eine Vielzahl von Bytetakt-Gruppen (200) umfasst,
worin jede der Vielzahl von Bytetakt-Gruppen einen Phaser (135) umfasst, der dazu konfiguriert ist, Schaltungselemente der Bytetakt-Gruppe mit einer Frequenz zu takten, mit der eine an die Bytetakt-Gruppe gekoppelte quellsynchrone Vorrichtung Daten kommuniziert;
worin jede Bytetakt-Gruppe außerdem umfasst:
einen Ausgangs-first-in-first-out-Speicher, auch FIFO-Speicher (235) genannt, innerhalb der E/A-Bank, mindestens zwei asynchron getaktete Ports umfassend, worin ein Eingangs-Port des Ausgangs-FIFO-Speichers mit einer ersten Betriebsfrequenz getaktet wird und ein Ausgangs-Port des Ausgangs-FIFO-Speichers durch den Phaser mit einer zweiten Betriebsfrequenz getaktet wird, die höher ist als die erste Betriebsfrequenz, die der quellsynchronen Vorrichtung entspricht; und
einen Eingangs-FIFO-Speicher (240) innerhalb der E/A-Bank, mindestens zwei asynchron getaktete Ports umfassend, worin ein Ausgangs-Port des Eingangs-FIFO-Speichers mit der ersten Betriebsfrequenz getaktet wird und ein Eingangsport des Eingangs-FIFO-Speichers durch den Phaser mit der zweiten Betriebsfrequenz getaktet wird;
eine Vielzahl von Eingangs-Serialisierern/Deserialisierern, auch SERDES (215) genannt, innerhalb der E/A-Bank, konfiguriert zum Deserialisieren von Daten, die von der quellsynchronen Vorrichtung empfangen werden, und zum Liefern der deserialisierten Daten an den Eingangs-Port des Eingangs-FIFO-Speichers; und
eine Vielzahl von Ausgangs-SERDES (210) innerhalb der E/A-Bank, konfiguriert zum Serialisieren von vom Ausgangs-Port des Ausgangs-FIFO-Speichers empfangen Daten, die an die quellsynchrone Vorrichtung auszugeben sind,
worin der Phaser innerhalb einer jeden der Vielzahl von Bytetakt-Gruppen dazu konfiguriert ist, Taktsignale mit der zweiten Betriebsfrequenz an jeden der Vielzahl von Eingangs-SERDES und jeden der Vielzahl von Ausgangs-SERDES der Bytetakt-Gruppe zu liefern.

2. Integrierte Schaltung nach Anspruch 1, worin der Phaser einer jeden der Vielzahl von Bytetakt-Gruppen unabhängig konfigurierbar ist.

3. Integrierte Schaltung nach einem der Ansprüche 1-2, worin die E/A-Bank außerdem umfasst:
eine physikalische Schnittstellensteuerung, konfiguriert zum Koordinieren des Betriebs eines jeden Phasers einer jeden der Vielzahl von Bytetakt-Gruppen,
worin die physikalische Schnittstellensteuerung eine Vielzahl von Timern umfasst, die spezifizieren, wann für jede Bytetakt-Gruppe der Phaser der Bytetakt-Gruppe Daten aus dem Ausgangs-FIFO-Speicher taktet und Daten in den Eingangs-FIFO-Speicher taktet.

4. Integrierte Schaltung nach einem der Ansprüche 1-3, außerdem umfassend:
eine Speichersteuerung, dazu konfiguriert, mit der ersten Betriebsfrequenz zu arbeiten,
worin die E/A-Bank an die Speichersteuerung gekoppelt ist,
worin die E/A-Bank dazu konfiguriert ist, mit der Speichersteuerung mit der ersten Betriebsfrequenz zu kommunizieren und mit einer Speichervorrichtung mit der zweiten Betriebsfrequenz zu kommunizieren.

5. Integrierte Schaltung nach einem der Ansprüche 1-4, worin der Phaser außerdem umfasst:
eine Pulssteuerung, konfiguriert zum Zählen von Pulsen von der quellsynchronen Vorrichtung, die in einem Strobesignal empfangen werden als Antwort auf eine erste Leseanforderung, worin die Pulssteuerung dazu konfiguriert ist, einen letzten Puls einer vorgegebenen Anzahl von erwarteten Pulsen zu detektieren; und
einen Multiplexer, an die Pulssteuerung gekoppelt und konfiguriert zum selektiven Weiterleiten des Strobesignals oder eines Referenzsignals als Antwort auf eine von der Pulssteuerung empfangene Anweisung, worin das Referenzsignal mit dem Strobesignal auf Phase und Frequenz abgestimmt ist,
worin, als Antwort darauf, dass die Pulssteuerung den letzten Puls detektiert, die Pulssteuerung dazu konfiguriert ist, den Multiplexer anzuweisen, das Referenzsignal anstelle des Strobesignals weiterzuleiten.

6. Integrierte Schaltung nach einem der Ansprüche 1-5, worin der Phaser außerdem umfasst:
eine Verzögerungsleitung, dazu konfiguriert, eine Verzögerungsgröße auf ein Referenzsignal anzuwenden;
mindestens einen Frequenzteiler, an die Verzögerungsleitung gekoppelt und dazu konfiguriert, ein erstes frequenzgeteiltes Signal und ein zweites frequenzgeteiltes Signal aus einer Version des Referenzsignals zu erzeugen, das aus der Verzögerungsleitung ausgegeben wird, worin das erste und das zweite frequenzgeteilte Signal eine identische Frequenz und eine verschiedene Phase haben;
einen Phasendetektor, konfiguriert zum Bestimmen eines Phasenverhältnisses zwischen einem Strobesignal und mindestens einem des ersten frequenzgeteilten Signals oder des zweiten frequenzgeteilten Signals; und
einen Ausgangsselektor, gekoppelt an den mindestens einen Frequenzteiler, worin der Ausgangsselektor dazu konfiguriert ist, das erste frequenzgeteilte Signal oder das zweite frequenzgeteilte Signal gemäß einem Zähler weiterzuleiten, der Anpassungen in der Verzögerungsgröße anzeigt, die durch die Verzögerungsleitung angewendet wird,
worin die Verzögerungsleitung die auf das Referenzsignal angewendete Verzögerungsgröße anpasst als Antwort auf das durch den Phasendetektor bestimmte Phasenverhältnis, und
worin, als Antwort auf das Überrollen der Verzögerungsleitung, das zweite frequenzgeteilte Signal ausgegeben wird.

7. Integrierte Schaltung nach einem der Ansprüche 1-6, worin der Phaser außerdem umfasst:
eine Vielzahl von Abtast-Flipflops, die ein Strobesignal überabtasten, worin jedes der Vielzahl von Abtast-Flipflops durch ein Taktsignal getaktet wird, das eine verschiedene Phase und ungefähr eine selbe Frequenz hat wie eine Frequenz des Strobesignals;
eine Steuerung, konfiguriert zum Detektieren einer Leseanforderung, die an die quellsynchrone Vorrichtung gesendet wird, und zum Bestimmen einer Zeitspanne zwischen der Leseanforderung und einem ersten Puls des Strobesignals gemäß Werten, die von der Vielzahl von Abtast-Flipflops empfangen werden, die das Strobesignal überabtasten; und
eine Rauschunterdrückungs-Schaltung, konfiguriert zur Torsteuerung des Strobesignals für die Zeitspanne als Antwort auf eine nachfolgende Leseanforderung.

8. Betriebsverfahren für eine integrierte Schaltung, auch IC genannt, wobei das Verfahren umfasst:
Definieren einer Vielzahl von Bytetakt-Gruppen (200) innerhalb einer Eingangs/Ausgangs-Bank, auch E/A-Bank (100) der IC genannt, worin jede Bytetakt-Gruppe einen Phaser (135) umfasst,
Taktschaltungselemente einer jeden Bytetakt-Gruppe unter Verwendung des Phasers der Bytetakt-Gruppe mit einer Frequenz, mit der eine an die Bytetakt-Gruppe gekoppelte quellsynchrone Vorrichtung kommuniziert;
Deserialisieren von Daten, die von der quellsynchronen Vorrichtung innerhalb einer Bytetakt-Gruppe der Vielzahl von Bytetakt-Gruppen empfangen werden;
Serialisieren von Daten, die an die quellsynchrone Vorrichtung innerhalb der Bytetakt-Gruppe der Vielzahl von Bytezahl-Gruppen auszugeben sind; und
für jede Bytetakt-Gruppe vom Phaser innerhalb der Bytetakt-Gruppe das Bereitstellen von:
Taktsignalen zur Deserialisierung und Serialisierung mit der Frequenz der quellsynchronen Vorrichtung;
einem Taktsignal zum Takten eines Ausgangs-Ports eines Ausgangs-first-in-first-out-Speichers, auch FIFO-Speicher (235) genannt, der in der E/A-Bank in der Bytetakt-Gruppe angeordnet ist, mindestens zwei asynchron getaktete Ports umfassend; und
einem Taktsignal zum Takten eines Eingangs-Ports eines Eingangs-FIFO-Speichers (240), der in der E/A-Bank in der Bytetakt-Gruppe angeordnet ist, mindestens zwei asynchron getaktete Ports umfassend;
worin sowohl ein Eingangs-Port des Ausgangs-FIFO-Speichers als auch ein Ausgangs-Port des Eingangs-FIFO-Speichers mit einer verschiedenen Frequenz getaktet ist, die niedriger ist als die Frequenz der quellsynchronen Vorrichtung.

9. Verfahren nach Anspruch 8, außerdem umfassend:
Betreiben einer Speichersteuerung mit einer ersten Betriebsfrequenz, worin die E/A-Bank an die Speichersteuerung gekoppelt ist, und
wobei die E/A-Bank mit der Speichersteuerung mit der ersten Betriebsfrequenz kommuniziert und mit einer Speichervorrichtung mit einer zweiten Betriebsfrequenz kommuniziert;
worin die erste Betriebsfrequenz die verschiedene Frequenz ist, die niedriger ist als die Frequenz der quellsynchronen Vorrichtung, und die zweite Betriebsfrequenz die Frequenz der quellsynchronen Vorrichtung ist.

10. Verfahren nach Anspruch 8 oder 9, außerdem umfassend:
Zählen von Pulsen von der quellsynchronen Vorrichtung, in einem Strobesignal empfangen, als Antwort auf eine erste Leseanforderung;
Detektieren eines letzten Pulses einer vorgegebenen Anzahl von erwarteten Pulsen; und
Weiterleiten eines Referenzsignals anstelle des Strobesignals als Antwort auf das Detektieren des letzten Pulses, worin das Referenzsignal mit dem Strobesignal auf Phase und Frequenz abgestimmt ist.

11. Verfahren nach einem der Ansprüche 8-10, außerdem umfassend:
Anwenden einer Verzögerungsspanne auf ein Referenzsignal;
Erzeugen eines ersten frequenzgeteilten Signals und eines zweiten frequenzgeteilten Signals aus einer Version des Referenzsignals, auf das die Verzögerungsgröße angewendet wird, worin das erste und das zweite frequenzgeteilte Signal eine gleiche Frequenz und eine verschiedene Phase haben;
Bestimmen eines Phasenverhältnisses zwischen einem Strobesignal und mindestens einem des ersten frequenzgeteilten Signals oder des zweiten frequenzgeteilten Signals;
Anpassen der Verzögerungsgröße, die auf das Referenzsignal als Antwort auf das Phasenverhältnis angewendet wird;
Weiterleiten des ersten frequenzgeteilten Signals oder des zweiten frequenzgeteilten Signals gemäß einem Zähler, der die Verzögerungsgröße anzeigt, die auf das Referenzsignal angewendet wird; und
als Antwort auf die Größe des Überrollens der Verzögerung, das Ausgeben des zweiten frequenzgeteilten Signals.

12. Verfahren nach einem der Ansprüche 8-11, außerdem umfassend:
Überabtasten eines Strobesignals unter Verwendung einer Vielzahl von Abtast-Flipflops, worin jedes der Vielzahl von Abtast-Flipflops durch ein Taktsignal getaktet wird, das eine verschiedene Phase und ungefähr eine selbe Frequenz hat wie eine Frequenz des Strobesignals;
Detektieren einer Leseanforderung, die an die quellsynchrone Vorrichtung gesendet wird;
Bestimmen einer Zeitspanne zwischen der Leseanforderung und einem ersten Puls des Strobesignals gemäß Werten, die von der Vielzahl von Abtast-Flipflops empfangen werden, die das Strobesignal überabtasten; und
Rauschunterdrückung des Strobesignals für die Zeitspanne, als Antwort auf eine nachfolgende Leseanforderung.

## Revendications

1. Circuit intégré, comprenant :
une barre omnibus d'entrée/sortie, également appelée barre omnibus I/O (100) comprenant une pluralité de groupes d'horloge d'octets (200) ;
dans lequel chaque groupe de la pluralité de groupes d'horloge d'octets comprend un synchronisateur (135) configuré de manière à cadencer des éléments de circuit du groupe d'horloge d'octets à une fréquence à laquelle un dispositif synchrone source couplé au groupe d'horloge d'octets communique des données ;
dans lequel chaque groupe d'horloge d'octets comprend en outre :
une mémoire de type « premier entré, premier sorti » de sortie, également appelée mémoire FIFO de sortie (235), dans la barre omnibus I/O, comprenant au moins deux ports cadencés de manière asynchrone, dans lequel un port d'entrée de la mémoire FIFO de sortie est cadencé à une première fréquence de fonctionnement et un port de sortie de la mémoire FIFO de sortie est cadencé par le synchronisateur à une seconde fréquence de fonctionnement, supérieure à la première fréquence de fonctionnement correspondant au dispositif synchrone source ; et
une mémoire FIFO d'entrée (240) dans la barre omnibus I/O comprenant au moins deux ports cadencés de manière asynchrone, dans lequel un port de sortie de la mémoire FIFO d'entrée est cadencé à la première fréquence de fonctionnement, et un port d'entrée de la mémoire FIFO d'entrée est cadencé par le synchronisateur à la seconde fréquence de fonctionnement ;
une pluralité de sérialiseurs/désérialiseurs d'entrée, également appelés SERDES (215), dans la barre omnibus I/O, configurés de manière à désérialiser des données reçues à partir du dispositif synchrone source, et à fournir les données désérialisées au port d'entrée de la mémoire FIFO d'entrée ; et
une pluralité de SERDES de sortie (210) dans la barre omnibus I/O, configurés de manière à sérialiser des données reçues, à partir du port de sortie de la mémoire FIFO de sortie, devant être générées en sortie vers le dispositif synchrone source ;
dans lequel le synchronisateur, au sein de chaque groupe de la pluralité de groupes d'horloge d'octets, est configuré de manière à fournir des signaux d'horloge à la seconde fréquence de fonctionnement à chacun de la pluralité de SERDES d'entrée et à chacun de la pluralité de SERDES de sortie du groupe d'horloge d'octets.

2. Circuit intégré selon la revendication 1, dans lequel le synchronisateur de chaque groupe de la pluralité de groupes d'horloge d'octets est configurable de manière indépendante.

3. Circuit intégré selon l'une quelconque des revendications 1 à 2, dans lequel la barre omnibus I/O comprend en outre :
un contrôleur d'interface physique configuré de manière à coordonner le fonctionnement de chaque synchronisateur de chaque groupe de la pluralité de groupes d'horloge d'octets ;
dans lequel le contrôleur d'interface physique comprend une pluralité de temporisateurs qui spécifient à quel moment, pour chaque groupe d'horloge d'octets, le synchronisateur du groupe d'horloge d'octets cadence des données en sortie à partir de la mémoire FIFO de sortie et cadence des données dans la mémoire FIFO d'entrée.

4. Circuit intégré selon l'une quelconque des revendications 1 à 3, comprenant en outre :
un contrôleur de mémoire configuré de manière à fonctionner à la première fréquence de fonctionnement ;
dans lequel la barre omnibus I/O est couplée au contrôleur de mémoire ;
dans lequel la barre omnibus I/O est configurée de manière à communiquer avec le contrôleur de mémoire à la première fréquence de fonctionnement, et à communiquer avec un dispositif de mémoire à la seconde fréquence de fonctionnement.

5. Circuit intégré selon l'une quelconque des revendications 1 à 4, dans lequel le synchronisateur comprend en outre :
un contrôleur d'impulsions configuré de manière à compter les impulsions en provenance du dispositif synchrone source, reçues dans un signal d'échantillonnage, en réponse à une première demande de lecture, dans lequel le contrôleur d'impulsions est configuré de manière à détecter une dernière impulsion d'un nombre prédéterminé d'impulsions attendues ; et
un multiplexeur couplé au contrôleur d'impulsions et configuré de manière à transmettre sélectivement le signal d'échantillonnage ou un signal de référence en réponse à une instruction reçue à partir du contrôleur d'impulsions, dans lequel le signal de référence est aligné en phase et en fréquence avec le signal d'échantillonnage ;
dans lequel, en réponse à la détection de la dernière impulsion par le contrôleur d'impulsions, le contrôleur d'impulsions est configuré de manière à commander au multiplexeur de transmettre le signal de référence au lieu du signal d'échantillonnage.

6. Circuit intégré selon l'une quelconque des revendications 1 à 5, dans lequel le synchronisateur comprend en outre :
une ligne à retard configurée de manière à appliquer une quantité de retard à un signal de référence ;
au moins un diviseur de fréquence couplé à la ligne à retard et configuré de manière à générer un premier signal divisé en fréquence et un second signal divisé en fréquence à partir d'une version du signal de référence généré en sortie à partir de la ligne à retard, dans lequel les premier et second signaux divisés en fréquence présentent une même fréquence et une phase différente ;
un détecteur de phase configuré de manière à déterminer une relation de phase entre un signal d'échantillonnage et au moins l'un parmi le premier signal divisé en fréquence ou le second signal divisé en fréquence ; et
un sélecteur de sortie couplé audit au moins un diviseur de fréquence, dans lequel le sélecteur de sortie est configuré de manière à transmettre le premier signal divisé en fréquence ou le second signal divisé en fréquence selon un compteur qui indique des ajustements en ce qui concerne la quantité de retard appliquée par la ligne à retard ;
dans lequel la ligne à retard ajuste la quantité de retard appliquée au signal de référence en réponse à la relation de phase déterminée par le détecteur de phase ; et
dans lequel, en réponse à un retournement de la ligne à retard, le second signal divisé en fréquence est généré en sortie.

7. Circuit intégré selon l'une quelconque des revendications 1 à 6, dans lequel le synchronisateur comprend en outre :
une pluralité de bascules bistables d'échantillonnage suréchantillonnant un signal d'échantillonnage, dans lequel chaque bascule de la pluralité de bascules bistables d'échantillonnage est cadencée par un signal d'horloge présentant une phase différente et une fréquence approximativement identique à la fréquence du signal d'échantillonnage ;
un contrôleur configuré de manière à détecter une demande de lecture envoyée au dispositif synchrone source et à déterminer une quantité de temps entre la demande de lecture et une première impulsion du signal d'échantillonnage, selon des valeurs reçues à partir de la pluralité de bascules bistables d'échantillonnage suréchantillonnant le signal d'échantillonnage ; et
un circuit de réglage silencieux configuré de manière à déclencher le signal d'échantillonnage pour la quantité de temps, en réponse à une demande de lecture subséquente.

8. Procédé d'exploitation pour un circuit intégré, également appelé IC, le procédé comprenant les étapes ci-dessous consistant à :
définir une pluralité de groupes d'horloge d'octets (200) au sein d'une barre omnibus d'entrée/sortie, également appelée barre omnibus I/O (100) du circuit IC, dans lequel chaque groupe d'horloge d'octets comprend un synchronisateur (135) ;
cadencer des éléments de circuit de chaque groupe d'horloge d'octets, en utilisant le synchronisateur du groupe d'horloge d'octets, à une fréquence à laquelle communique un dispositif synchrone source couplé au groupe d'horloge d'octets ;
désérialiser des données reçues à partir du dispositif synchrone source au sein d'un groupe d'horloge d'octets de la pluralité de groupes d'horloge d'octets ;
sérialiser des données devant être générées en sortie vers le dispositif synchrone source au sein du groupe d'horloge d'octets de la pluralité de groupes d'horloge d'octets ; et
pour chaque groupe d'horloge d'octets, fournir, à partir du synchronisateur au sein du groupe d'horloge d'octets :
des signaux d'horloge pour la désérialisation et la sérialisation à la fréquence du dispositif synchrone source ;
un signal d'horloge destiné à cadencer un port de sortie d'une mémoire de type « premier entré, premier sorti » de sortie, également appelée mémoire FIFO de sortie (235), se trouvant dans la barre omnibus I/O dans le groupe d'horloge d'octets comprenant au moins deux ports cadencés de manière asynchrone ; et
un signal d'horloge destiné à cadencer un port d'entrée d'une mémoire FIFO d'entrée (240) se trouvant dans la barre omnibus I/O dans le groupe d'horloge d'octets comprenant au moins deux ports cadencés de manière asynchrone ;
dans lequel un port d'entrée de la mémoire FIFO de sortie et un port de sortie de la mémoire FIFO d'entrée sont chacun cadencés à une fréquence différente, inférieure à la fréquence du dispositif synchrone source.

9. Procédé selon la revendication 8, comprenant en outre l'étape ci-dessous consistant à :
exploiter un contrôleur de mémoire à une première fréquence de fonctionnement, dans lequel la barre omnibus I/O est couplée au contrôleur de mémoire ; et
la barre omnibus I/O communiquant avec le contrôleur de mémoire à la première fréquence de fonctionnement et communiquant avec un dispositif de mémoire à une seconde fréquence de fonctionnement ;
dans lequel la première fréquence de fonctionnement correspond à la fréquence différente, inférieure à la fréquence du dispositif synchrone source, et la seconde fréquence de fonctionnement correspond à la fréquence du dispositif synchrone source.

10. Procédé selon la revendication 8 ou 9, comprenant en outre les étapes ci-dessous consistant à :
compter les impulsions en provenance du dispositif synchrone source, reçues dans un signal d'échantillonnage en réponse à une première demande de lecture ;
détecter une dernière impulsion d'un nombre prédéterminé d'impulsions attendues ; et
transmettre un signal de référence à la place du signal d'échantillonnage, en réponse à la détection de la dernière impulsion, dans lequel le signal de référence est aligné en phase et en fréquence avec le signal d'échantillonnage.

11. Procédé selon l'une quelconque des revendications 8 à 10, comprenant en outre les étapes ci-dessous consistant à :
appliquer une quantité de retard à un signal de référence ;
générer un premier signal divisé en fréquence et un second signal divisé en fréquence à partir d'une version du signal de référence auquel la quantité de retard est appliquée, dans lequel les premier et second signaux divisés en fréquence présentent une même fréquence et une phase différente ;
déterminer une relation de phase entre un signal d'échantillonnage et au moins l'un parmi le premier signal divisé en fréquence ou le second signal divisé en fréquence ;
ajuster la quantité de retard appliquée au signal de référence en réponse à la relation de phase ; et
transmettre le premier signal divisé en fréquence ou le second signal divisé en fréquence selon un compteur qui indique la quantité de retard appliquée au signal de référence ; et
en réponse à une quantité de retournement de retard, générer en sortie le second signal divisé en fréquence.

12. Procédé selon l'une quelconque des revendications 8 à 11, comprenant en outre les étapes ci-dessous consistant à :
suréchantillonner un signal d'échantillonnage en utilisant une pluralité de bascules bistables d'échantillonnage, dans lequel chaque bascule de la pluralité de bascules bistables d'échantillonnage est cadencée par un signal d'horloge présentant une phase différente et une fréquence approximativement identique à la fréquence du signal d'échantillonnage ;
détecter une demande de lecture envoyée au dispositif synchrone source ;
déterminer une quantité de temps entre la demande de lecture et une première impulsion du signal d'échantillonnage, selon des valeurs reçues à partir de la pluralité de bascules bistables d'échantillonnage suréchantillonnant le signal d'échantillonnage ; et
mettre en sourdine le signal d'échantillonnage pour la quantité de temps, en réponse à une demande de lecture subséquente.
